(19)

**Europäisches Patentamt**

**European Patent Office**

**Office européen des brevets**

(11) **EP 4 528 792 A2**

(12) **EUROPEAN PATENT APPLICATION**

(43) Date of publication:
**26.03.2025 Bulletin 2025/13**

(21) Application number: **24195635.8**

(22) Date of filing: **21.08.2024**

(51) International Patent Classification (IPC):
**H01L 21/56** (2006.01)   **H01L 21/683** (2006.01)
**H01L 25/065** (2023.01)   **H01L 21/67** (2006.01)
**H01L 25/10** (2006.01)

(52) Cooperative Patent Classification (CPC):
**H01L 21/561; H01L 21/6835; H01L 21/6836;**
**H01L 25/0655;** H01L 21/67005; H01L 25/0652;
H01L 25/105; H01L 2221/68304; H01L 2221/68318;
H01L 2221/68322; H01L 2221/6834;
H01L 2221/68363; H01L 2221/68368;
H01L 2221/68381; H01L 2225/06548

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.09.2023 US 202318473905**

(71) Applicant: **Intel Corporation
Santa Clara, CA 95054 (US)**

(72) Inventors:
• **ELSHERBINI, Adel A.**
  **Chandler, 85248 (US)**
• **SOUNART, Thomas L.**
  **Chandler, 85226 (US)**
• **EID, Feras**
  **Chandler, 85226 (US)**
• **TALUKDAR, Tushar**
  **Wilsonville, 97124 (US)**

• **RAWLINGS, Brandon M.**
  **Chandler, 85248 (US)**
• **VYATSKIKH, Andrey**
  **Hillsboro, 97123 (US)**
• **BEDOYA ARROYAVE, Carlos Felipe**
  **Portland, 97209 (US)**
• **JUN, Kimin**
  **Portland, 97229 (US)**
• **LIFF, Shawna M.**
  **Scottsdale, 85255 (US)**
• **KLOSTER, Grant**
  **Lake Oswego, 97035 (US)**
• **VREELAND, Richard**
  **Beaverton, 97006 (US)**
• **BREZINSKI, William**
  **Beaverton, 97008 (US)**
• **SWAN, Johanna M.**
  **Scottsdale, 85255 (US)**

(74) Representative: **2SPL Patentanwälte PartG mbB
Landaubogen 3
81373 München (DE)**

(54) **SELECTIVE LAYER TRANSFER**

(57)   Methods of selectively transferring portions of layers between substrates, and devices and systems formed using the same, are disclosed herein. In one embodiment, a first substrate with a layer of integrated circuit (IC) components is received, and a second substrate with one or more adhesive areas is received. The first substrate is partially bonded to the second substrate, such that a subset of IC components on the first substrate are bonded to the adhesive areas on the second substrate. The first substrate is then separated from the second substrate, and the subset of IC components bonded to the second substrate are separated from the first substrate and remain on the second substrate.

EP 4 528 792 A2

## Description

## BACKGROUND

In semiconductor manufacturing, layer transfer techniques are used to transfer a layer from one substrate to another, typically at wafer-level scale. These techniques require a full layer to be transferred in its entirety regardless of whether the entire layer is needed. As a result, any unneeded portions of a transferred layer must be etched off after the transfer, which increases costs and process complexity.

## BRIEF DESCRIPTION OF THE DRAWINGS

    **FIGS. 1A-I** illustrate an example process flow for selective layer transfers using selective release techniques.
    **FIGS. 2A-I** illustrate an example process flow for selective layer transfers using a blanket laser exposure.
    **FIGS. 3A-I** illustrate an example process flow for selective layer transfers from a singulated donor substrate.
    **FIGS. 4A-C** illustrate an example process flow for selective layer transfers from multiple donor substrates.
    **FIGS. 5A-F** illustrate an example process flow for forming an integrated circuit package using a selective transfer of a passive interposer.
    **FIGS. 6A-B** illustrate an example of a selective layer transfer between wafers.
    **FIG. 7** illustrates a flowchart for performing selective layer transfers.
    **FIGS. 8A-E** illustrate an example process flow for selective transfers using blanket wafer laser exposure.
    **FIGS. 9A-D** illustrate an example process flow for selective transfers using a structured release layer with residual adhesion anchors.
    **FIGS. 10A-C** illustrate patterned release layer structures to control residual adhesion using anchors.
    **FIG. 11** illustrates an example embodiment of a bond/debond tool for selective transfers.
    **FIGS. 12A-C** illustrate various laser debonding techniques for selective transfers.
    **FIG. 13** illustrates a graph of the debonding time for selective transfers using various laser debonding techniques.
    **FIGS. 14A-B** illustrate a selective transfer process flow for avoiding contact between the surface of a donor wafer and a wafer chuck.
    **FIG. 15** illustrates a top view of a wafer and dies that may be included in a microelectronic assembly.
    **FIG. 16** illustrates a cross-sectional side view of an integrated circuit device that may be included in a microelectronic assembly.
    **FIGS. 17A-D** illustrate perspective views of example planar, FinFET, gate-all-around, and stacked gate-all-around transistors.
    **FIG. 18** illustrates a cross-sectional side view of an integrated circuit device assembly that may include a microelectronic assembly.
    **FIG. 19** illustrates a block diagram of an example electrical device that may include a microelectronic assembly.

## DETAILED DESCRIPTION

*Selective Layer Transfer*

In semiconductor manufacturing, layer transfer techniques are used to transfer a layer from one substrate to another, typically at wafer-level scale. Layer transfers are useful for a variety of applications in semiconductor manufacturing, including two-dimensional (2D) material fabrication, Group III-V semiconductors over complementary metal-oxide semiconductors (CMOS), and traditional CMOS applications such as metal-insulator-metal (MIM) devices and thin device and/or interconnect layer transfers. Current layer transfer techniques are limited to full layer transfers, however, which may impact cost and performance when the full layer is not needed. For example, blanket layer transfer techniques, such as ion-cut and laser debonding layer transfers, require a full layer to be transferred in its entirety. As a result, any unneeded areas of the transferred layer must be etched off after the transfer, which results in added cost and process complexity.

Alternatively, pick-and-place techniques can be used to transfer specific dies or chiplets. For example, a chiplet generally refers to an integrated circuit (IC) that contains a well-defined subset of functionality, which is designed to be combined with other chiplets to form a single IC package. To transfer chiplets (e.g., for MIM chiplet integration in a system-on-a-chip (SoC)), chiplet devices are fabricated on a donor substrate (e.g., a wafer or panel), the donor substrate is singulated into chiplets, and the chiplets are then individually attached to a receiver substrate (e.g., an SoC wafer or package) using pick-and-place machines. This adds significant cost due to the extra processing required to singulate the wafer and individually attach the respective chiplet dies. For example, chiplets are generally manufactured on relatively thick substrates to enable them to be handled during the singulation and attach steps without being damaged, and after the attach step, additional processing is performed to thin the chiplets and/or remove the carrier substrate, which further increases the cost and process complexity. In particular, chiplets are typically manufactured on substrates that are over 700 micrometers ($\mu$m or microns) thick to provide structural and mechanical stability during fabrication, and after the singulation/attach steps, they may be thinned to approxi-

mately 20-100 $\mu$m by grinding the backside. However, grinding typically causes chipping along the edges of the chiplet dies. Further, it can be challenging to thin chiplets beyond 20 $\mu$m without producing defects. Similarly, chiplets are typically singulated with a die area on the millimeter level scale, as pick-and-place assembly becomes very challenging for chiplets smaller than 1 millimeter (mm)$^2$.

Integrated circuits can also be manufactured monolithically, where all IC components and interconnections are fabricated sequentially on the same underlying substrate or wafer. Monolithic ICs have various limitations, however, including design limitations due to incompatible processes, lack of flexibility, and low yield.

Accordingly, this disclosure presents selective layer transfer techniques for selectively transferring portions of a layer between substrates, along with devices and systems formed using the same. For example, the described techniques enable select areas of a donor substrate to be transferred to a receiver substrate, which enables the donor substrate to be reused multiple times, while also addressing the limitations described above for blanket layer transfers and pick and place techniques. In particular, the described solution uses a selective release technology on a donor substrate (e.g., wafer, panel, or die) in conjunction with a patterned bonding template on a receiver substrate (e.g., wafer, panel, or die) to allow select areas of a layer on the donor substrate to be transferred to the receiver substrate. For purposes of this disclosure, a layer may refer to one or more layers formed over a substrate, such as an individual layer of material, or a stack of layers that collectively form a layer of IC components (e.g., dies, interconnects, bridges, capacitors, and/or other semiconductor devices). A layer may also include stacked wafers, such as wafer-to-wafer bonded and stacked logic and/or memory wafers. As an example, a donor wafer may include a layer of IC components (e.g., IC dies), and a selective layer transfer may be used to selectively and simultaneously transfer a specific subset of those IC components to a receiver wafer.

The described solution provides various advantages. For example, the described solution enables select areas of a donor wafer to be transferred as opposed to an entire layer, which enables the donor wafer to be reused for multiple products, thus amortizing the cost of expensive devices (e.g., high-density MIM capacitors or high-density passive interposers) across multiple wafers. This solution also eliminates the need to etch away superfluous areas as required by full layer transfers (and as a result, unlike the etched areas after a full layer transfer, selectively transferred areas may not have tapered edges from etching or may have reversed tapering due to the etch to singulate before transfer).

Further, layers of IC components can be selectively transferred at any level of granularity, including full IC dies and packages, interconnects, transistors, resistors, capacitors, partial layers or layer stacks, etc.

This solution also enables areas of ultra-thin layers to be selectively transferred without the added processing and yield loss resulting from the handling challenges of chiplet pick-and-place methods (e.g., singulation, individually attaching each chiplet, post-attach thinning of chiplets). This helps reduce the Z-height of a product (e.g., for formfactor, thermal, and/or power delivery reasons) as well as the overall process complexity. For example, very thin IC dies or chiplets can be formed on any substrate and selectively transferred directly from that substrate. As a result, selectively transferring the dies not only eliminates the need for post-attach thinning, it also enables the dies to be much thinner than dies that are singulated, pick-and-place attached, and then subsequently thinned. In some cases, for example, the described solution may enable transfers of dies with thicknesses ranging from 100 nanometers (nm) to 5 $\mu$m or more. Further, since no post-attach thinning is needed, the selectively transferred dies may have no or minimal chipping on the die edges since no grinding is performed, unlike chiplets that are thinned after attachment.

Similarly, this solution supports selective transfers of very small areas on a donor substrate, such as very small dies or chiplets, which is extremely challenging using pick-and-place techniques. In some cases, for example, the described solution may enable transfers of dies (or other IC components) with an area less than 1 mm$^2$, such as 100 $\mu$m$^2$ (10x10 $\mu$m), 10,000 $\mu$m$^2$ (100x100 $\mu$m), 810,000 $\mu$m$^2$ (900x900 $\mu$m), etc. (with no limits on the maximum size of an area that can be selectively transferred).

This solution also supports selective transfers of dies with non-standard shapes and designs that are difficult to handle using pick-and-place machines, such as dies with atypical, arbitrary, irregular, or non-convex shapes (e.g., L shape, U shape, shapes with acute angles), dies with high aspect ratios (e.g., 8:1 aspect ratio or higher), dies with holes, and so forth.

Further, this solution has very low topography and supports high surface cleanliness and planarization (e.g., using chemical mechanical polishing (CMP) processing), which makes it compatible with hybrid bonding and fusion bonding processing. Additional advantages are described throughout this disclosure and apparent from the description below.

Accordingly, this solution enables complex IC packages and products to be manufactured by selectively transferring certain components (e.g., active circuitry such as IC dies, passive circuitry) instead of incorporating them using traditional processes, such as: (i) full layer transfers with superfluous areas etched away; (ii) pick-and-place assembly of individual IC components; and/or (iii) monolithic IC fabrication.

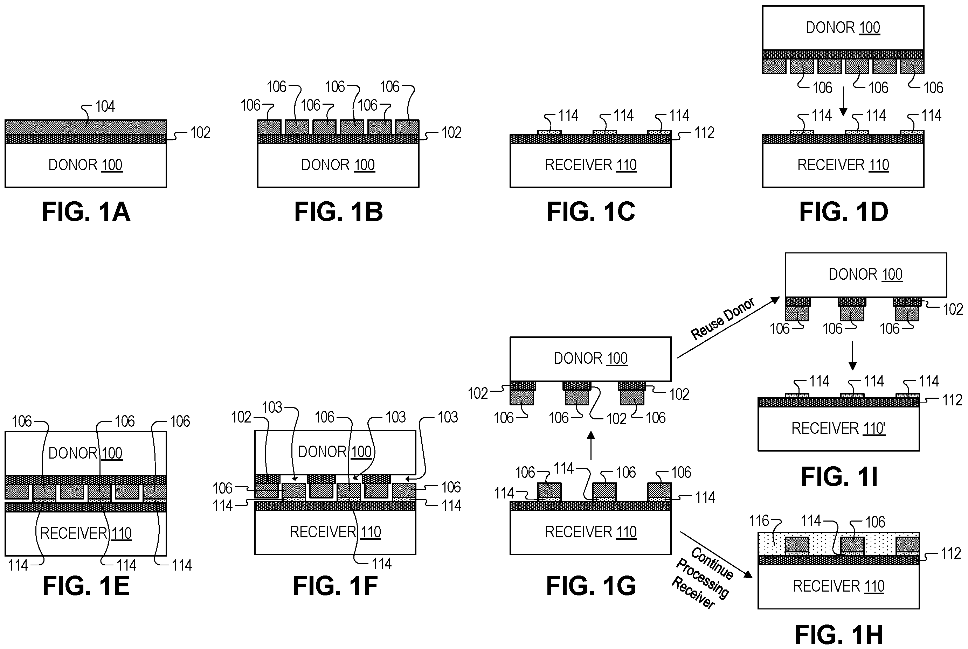

FIGS. 1A-I illustrate an example process flow for selective layer transfers using selective release techniques. In the illustrated example, a layer of integrated circuit (IC) components is selectively transferred from a donor substrate 100 to a receiver substrate 110, as described further below.

In FIG. 1A, a release layer 102 is formed over a carrier substrate, which is referred to as the donor substrate 100. The release layer 102 is a temporary bonding and debonding layer for the layer 104 to be selectively transferred. In some embodiments, the release layer 102 may include one or more layers and/or materials capable of providing adhesion to the donor substrate 100 and/or absorbing energy from a laser (e.g., laser beams), such as lossy dielectric and/or thin metal layer(s) that provide adhesion and absorb/reflect infrared (IR) light, organic polymer layer(s) (e.g., polyimides) that provide adhesion and absorb visible or ultraviolet (UV) light, and/or patterned dielectric layer(s) with anchors to provide residual adhesion (e.g., after the metal layer is ablated by an IR laser).

The layer 104 to be selectively transferred is formed over the release layer 102 of the donor substrate 100, such as by fabricating the layer 104 directly or blanket transferring the layer 104. The selective transfer layer 104 may include one or more layers of material, such as a single layer of material or a stack of layers that collectively form a layer of IC components (e.g., full IC dies, chiplets, interconnects, bridges, capacitors, transistors, and/or other semiconductor devices). In some embodiments, for example, the selective transfer layer 104 may be a prefabricated semiconductor wafer containing unsingulated integrated circuit (IC) dies, which is blanket transferred to the release layer 102 on a donor wafer 100.

In FIG. 1B, the selective transfer layer 104 is diced over the donor substrate 100-without dicing through the donor substrate 100-to partially singulate the IC components 106 in the layer 104, using techniques such as etching, reactive ion etching (RIE), plasma dicing, mechanical sawing, etc. In some embodiments, the release layer 102 may also be singulated (e.g. diced or etched) along with the transfer layer 104.

In FIG. 1C, a release layer 112 is optionally formed over another carrier substrate, which is referred to as the receiver substrate 110. For example, the release layer 112 may be formed over the receiver substrate 110 if the selectively transferred IC components 106 will be subsequently debonded from the receiver substrate 110 after the transfer. Otherwise, if the selectively transferred IC components 106 will remain on the receiver substrate 110 after the transfer, the release layer 112 on the receiver 110 may be omitted.

Next, a bonding template 114 is formed on the surface of the receiver substrate 110 (e.g., above the release layer 112, if included). The bonding template 114 includes a pattern of bonding features or adhesive areas 114 that enable specific areas of the donor substrate 100 to be selectively transferred to the receiver substrate 110. For example, the positions of the bonding features 114 on the receiver substrate 110 correspond to the areas or IC components 106 on the donor substrate 100 that will be transferred to the receiver substrate 110.

In some embodiments, for example, the bonding features 114 may include "island" or "mesa" structures that are similar in size to the target areas to be transferred from the donor substrate 100. For example, each island or mesa structure 114 may be a raised structure on the surface of the receiver substrate 110 with a similar footprint (e.g., shape/surface area) as a corresponding IC component 106 on the donor substrate 100. In other embodiments, the mesas 114 may be replaced by lithographically or additively manufactured surface treatments that enhance the adhesion in the target areas of the receiver substrate 110 (e.g., the areas where the mesas 114 are shown) and prevents adhesion in the other areas, including, without limitation, surface topography variations, use of materials with high and/or low adhesion, treatments using hydrophobic materials and/or self-assembled monolayers (SAMs), and/or surface activation techniques, among other examples.

In various embodiments, these bonding features 114 may be made of dielectric materials, conductive materials (e.g., metal), or both, depending on whether electrical connections are needed between the bonded IC components 106 and the receiver substrate 110. For example, the bonding features 114 may be blanket dielectric structures with no electrical contacts, or they may be dielectric structures with electrical contacts through them (e.g., hybrid bonding pads) if electrical connections are needed through the bonding interface.

In FIG. 1D, the donor and receiver substrates 100, 110 are brought into contact with each other with their top surfaces aligned face to face, such that the target IC components 106 on the donor 100 are aligned with corresponding bonding features 114 on the receiver 110.

In FIG. 1E, the donor and receiver substrates 100, 110 are partially bonded together. For example, the areas of the receiver substrate 110 with protruding surface features or "mesas" 114 are bonded to corresponding areas of the donor substrate 110 with the target IC components 106, while other areas of the donor and receiver substrates 100, 110 remain unbonded. In some embodiments, for example, this is controlled through the height of the bonding protrusions 114 to prevent unwanted contact between areas that are not to be transferred. As previously mentioned, this can also be controlled through surface treatment of the different areas to enable good adhesion in the target areas (e.g., where the mesas 114 are shown) and prevent or reduce adhesion in other areas.

In FIG. 1F, the IC components 106 bonded to the receiver 110 are selectively debonded from the donor 100 using selective release techniques, such as IR debonding, selective visible or ultraviolet (UV) laser exposure, etc. For example, areas 103 of the release layer 102 where those IC components 106 are bonded to the donor 100 may be selectively removed or ablated using a laser, such as an IR or UV laser, which forms gaps or voids 103 in the release layer 102 and causes those IC components 106 to be released from the donor 100.

In FIG. 1G, the donor and receiver substrates 100, 110 are mechanically separated from each other. At this point, the IC components 106 that were selectively bonded to the receiver 110 (e.g., via the bonding structures 114) and debonded from the donor 100 remain on the receiver 110 and are separated from the donor 100. All other IC components 106 that were not bonded to the receiver 110 remain on the donor 100.

In FIG. 1H, the receiver substrate 110 is now ready for continued processing, such as dielectric fill 116 around the transferred IC components 106, planarization, selectively transferring or pick-and-place attaching additional IC dies or other IC components, via formation, formation of interconnect/metallization layers, attaching a structural substrate, debonding the receiver substrate (e.g., via the optional receiver release layer 112), and/or any other processing required for the finished product (e.g., an IC package).

In FIG. 1I, the donor substrate 100 is then reused to transfer the remaining IC components 106 (e.g., the remaining areas of the selectively transferred layer 104) to a new receiver substrate 110'. The donor substrate 100 can continue being reused in this manner until all IC components 106, or the entire layer 104, have been selectively transferred to any number of receiver substrates 110.

It should be appreciated that the illustrated process flow for selective layer transfers is merely presented as an example and many other process variations are also possible. For example, the donor and receiver substrates 100, 110 may be wafers, panels, IC packages, chiplets, dies, or any combination thereof (e.g., for transfers from wafer to panel, chiplet to wafer, etc.). Moreover, each substrate 100, 110 may be made of a variety of materials, including, without limitation, inorganic materials such as silicon, silicon on insulator (SOI), quartz, glass, and/or Group III-V materials, organic materials such as IR or UV transparent epoxies, and so forth.

The materials used in the release layers 102, 112 may vary depending on the type of release or debonding technology used. For example, for infrared (IR) laser debonding, the release layers 102, 112 may include one or more materials capable of absorbing and/or reflecting infrared (IR) light, such as a thin metal layer or multiple metal layers (e.g., aluminum (Al), tungsten (W), copper (Cu), titanium (Ti), titanium nitride (TiN), tantalum (Ta), tantalum nitride (TaN)). For ultraviolet (UV) laser debonding, the release layers 102, 112 may include one or more materials capable of absorbing UV light (e.g., a wide range of organic polymers, including, but not limited to, polyimides). In some embodiments, the release layers 102, 112 may additionally or alternatively include one or more layers of dielectric materials (e.g., silicon dioxide ($SiO_2$), silicon nitride ($Si_3N_4$), silicon oxynitride (SiON), silicon carbide (SiC), silicon carbon nitride (SiCN), silicon oxycarbon nitride (SiOCN), aluminum oxide ($Al_2O_3$), low-k dielectrics such as carbon-doped oxide (CDO) or porous silicon dioxide ($SiO_2$), titanium dioxide ($TiO_2$), tanta-

lum oxide ($Ta_2O_5$)), which may be used to buffer laser ablation and thermal energy, control thin film interference or adhesion, and/or provide residual adhesion after other materials and/or layers in the release layers 102, 112 are weakened, removed, and/or ablated by a laser.

The number of layers 104 on the donor substrate 100, the arrangement/structure of the layers 104, the materials in each layer 104, and the type of IC components 106 formed in those layers 104 may vary.

The adhesive areas or bonding features 114 on the receiver substrate 110 may be formed using any suitable surface treatments or other techniques to control the level of adhesion in different areas, including, without limitation, surface topography variations (e.g., mesas, recesses), use of materials with high and/or low adhesion, treatments using hydrophobic materials and/or self-assembled monolayers (SAMs), and/or surface activation techniques, among other examples. Moreover, the bonding features or adhesive areas 114 on the receiver substrate 110 may vary in size, shape, height, topography, pattern, and materials. For example, the bonding features 114 may be formed using inorganic dielectrics such as silicon dioxide ($SiO_2$), silicon nitride ($Si_3N_4$), silicon oxy nitride (SiON), and/or silicon carbon nitride (SiCN), organic dielectrics such as photoresists and adhesives, conductive materials such as metals, and combinations thereof.

The donor and receiver substrates 100, 110 may be (partially) bonded using any suitable bonding techniques, including, without limitation, hybrid bonding, fusion bonding, and adhesive bonding. The donor and receiver substrates 100, 110 may be debonded or released using any suitable debonding techniques, including, without limitation, IR and UV laser debonding. Further, there may be additional cleaning steps to reuse the donor substrate 100 before or after each selective layer transfer to a receiver substrate 110.

Further, in some embodiments, additional bonding and/or alignment features may be included at the wafer level and/or die level (e.g., on the donor dies, donor wafer, receiver wafer, and/or final product). For example, the donor and/or receiver wafer may include ridge or cross structures to facilitate bonding, such as a single ridge (e.g., a line or strip of dielectric material) extending across and/or through the center of the wafer, or multiple orthogonal ridges forming a cross-like pattern. Alignment features for wafers, die-lets, and/or die arrays may also be included to facilitate bonds with proper alignment. Further, multiple dies may be connected by small (e.g., dielectric) bridges to help them collectively bond and transfer together. For example, if some of the bridge-connected dies successfully bond to the receiver, the bridges may help others bond as well. Thus, these inter-die bridges may be present on the donor before the transfer, and on the receiver and final product after the transfer.

Further, in some cases, the debonding process may cause some unique damage or delamination near the edge and/or on the back of the dies, which does not impact process performance but may be indicative of this solution being used.

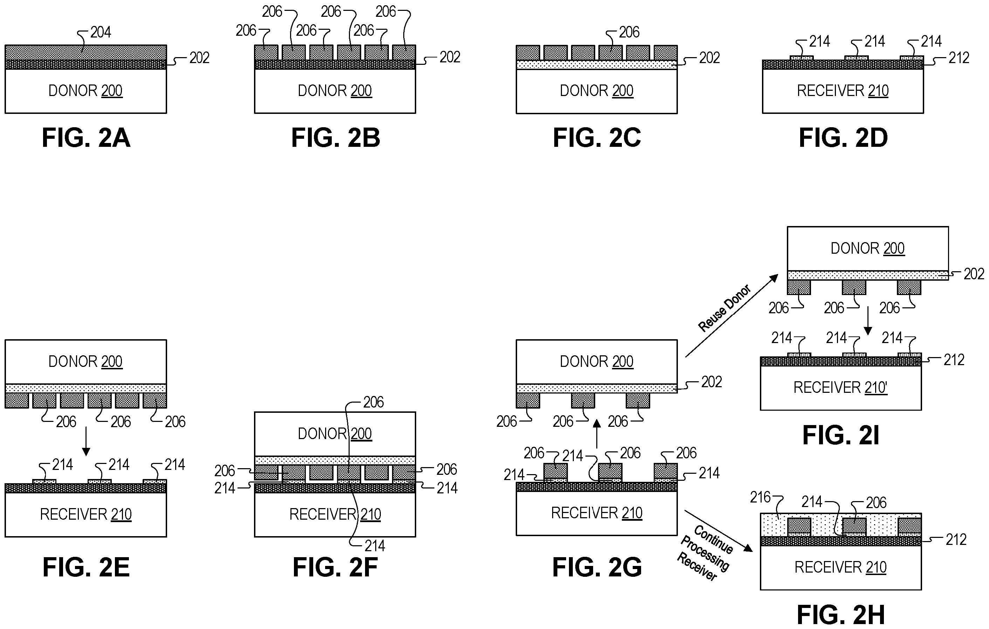

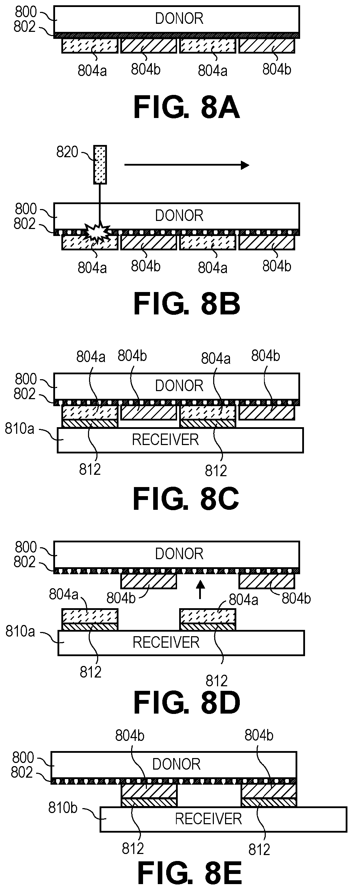

**FIGS. 2A-I** illustrate an example process flow for selective layer transfers using a blanket laser exposure. In the illustrated example, a layer 204 of integrated circuit (IC) components 206 is selectively transferred from a donor substrate 200 to a receiver substrate 210. Prior to the transfer, however, the entire release layer 202 on the donor 200 is mechanically weakened (e.g., using IR laser, visible light laser, UV laser, chemical etching, and/or thermal techniques), which may also be referred to as a partial release. In this manner, after the target IC components 206 on the donor 200 are bonded to the receiver 210, they can be fully released from the donor 200 by mechanically separating the donor 200 from the receiver 210. In some cases, this may result in a simplified and faster bond/debond flow compared to the bond/selective release/debond flow of FIGS. 1A-I. Other variations of this flow are described in connection with FIGS. 8-14. Alternatively, rather than using blanket laser exposure, the respective materials used in the donor release layer 202 and the receiver bonding template 214 may be selected such that the bond to the donor 200 is weaker than the subsequently formed bond to the receiver 210.

In FIG. 2A, a release layer 202 is formed over a donor substrate 200. The layer 204 to be selectively transferred is formed over the release layer 202, such as by fabricating the layer 204 directly or blanket transferring the layer 204. In some embodiments, the selective transfer layer 204 may be a layer of IC components (e.g., IC dies, chiplets, interconnects, bridges, capacitors, transistors, and/or other semiconductor devices).

In FIG. 2B, the selective transfer layer 204 is diced over the donor substrate 200-without dicing through the donor substrate 200-to partially singulate the IC components 206 in the layer 204.

In FIG. 2C, blanket laser exposure is performed on the donor release layer 202 to weaken the entire release layer 202 prior to the transfer. In some embodiments, for example, blanket laser exposure may be performed using laser (e.g., IR or UV laser exposure), chemical, and/or thermal techniques. In this manner, the weakened release layer 202 has lower bond energy, which results in a partial release of the IC components 206 bonded to that layer 202.

In FIG. 2D, a release layer 212 is optionally formed over a receiver substrate 210. For example, if the selectively transferred IC components 206 will be subsequently debonded from the receiver substrate 210 after the transfer, a release layer 212 may be formed over the receiver 210; otherwise, the release layer 212 on the receiver 210 may be omitted.

Next, a bonding template 214 is formed on the surface of the receiver substrate 210 (e.g., above the release layer 212, if included). The bonding template 214 includes a pattern of bonding features or adhesive areas 214, such as mesas, that enable specific areas of the donor substrate 200 to be selectively transferred to the receiver substrate 210. In various embodiments, however, any suitable surface treatments or other techniques may be used to control the level of adhesion on different areas of the receiver substrate 210 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 2E, the donor and receiver substrates 200, 210 are brought into contact with each other with their top surfaces aligned face to face, such that the target IC components 206 on the donor 200 are aligned with corresponding bonding features 214 on the receiver 210.

In FIG. 2F, the donor and receiver substrates 200, 210 are partially bonded together, where the areas of the donor 200 with the target IC components 206 are bonded to the areas on the receiver 210 with bonding mesas 214.

In FIG. 2G, the donor and receiver substrates 200, 210 are mechanically separated from each other. At this point, the IC components 206 that were selectively bonded to the receiver 210 (e.g., via the bonding mesas 214) remain on the receiver 210 and are debonded/separated from the donor 200 due to the blanket weakening of the donor release layer 202. All other IC components 206 that were not bonded to the receiver 210 remain on the donor 200.

Alternatively, in some embodiments, instead of (or in addition to) performing blanket laser exposure in FIG. 2C, the respective materials used in the donor release layer 202 and the receiver bonding template 214 may be selected such that the target IC components 206 will have a stronger bond to the receiver 210 than the donor 200. In this manner, when the donor 200 and receiver 210 are mechanically separated, the target IC components 206 will debond from the donor 200 and remain on the receiver 210 due to the disparity in bond strength.

In FIG. 2H, the receiver substrate 210 is ready for continued processing, such as dielectric fill 216 around the transferred IC components 206, planarization, selectively transferring or pick-and-place attaching additional IC dies or other IC components, via formation, formation of interconnect/metallization layers, attaching a structural substrate, debonding the receiver substrate (e.g., via the optional receiver release layer 212), and/or any other processing required for the finished product (e.g., an IC package).

In FIG. 2I, the donor substrate 200 is then reused to transfer the remaining IC components 206 (e.g., the remaining areas of the selectively transferred layer 204) to a new receiver substrate 210'. The donor substrate 200 can continue being reused in this manner until all IC components 206, or the entire layer 204, have been selectively transferred to any number of receiver substrates 210.

Elements labeled with reference numerals in FIGS. 2A-I may be similar to those having similar reference numerals in FIGS. 1A-I. Further, it should be appreciated that the illustrated process flow for selective layer transfers is merely presented as an example and many other process variations are also possible, including, but not limited to, the process variations described throughout this disclosure.

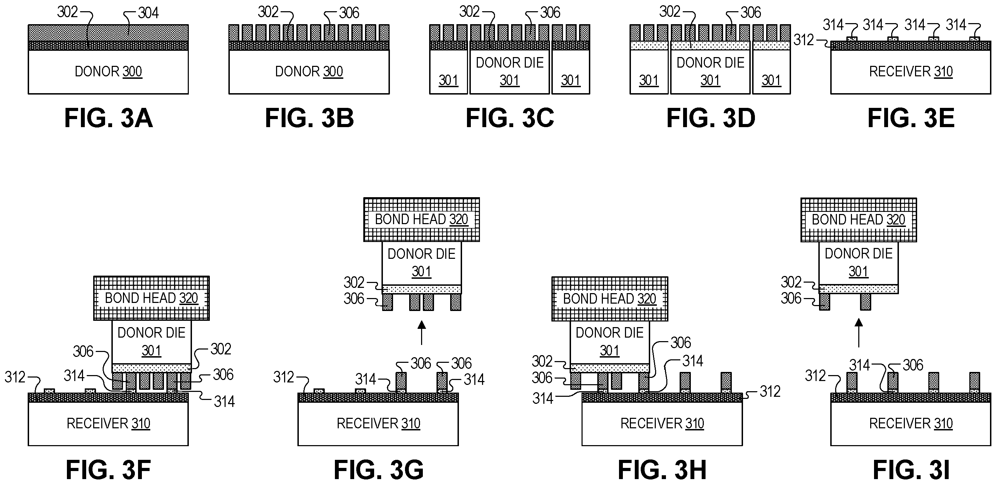

**FIGS. 3A-I** illustrate an example process flow for selective layer transfers from a singulated donor substrate 300. In some cases, for example, if the percentage of transferred integrated circuit (IC) components 306 is relatively small for each selective layer transfer, it may be easier and more cost efficient to dice the donor substrate 300 and perform the transfers from singulated donor dies 301 that contain smaller subsets of IC components 306 from the original donor substrate 300. Accordingly, in the illustrated example, a donor substrate 300 with a layer 304 of IC components 306 is diced, and the resulting layer of IC components 306 on a singulated donor die 301 is selectively transferred to a receiver substrate 310. In this manner, the transfers are performed at the donor die level rather than the wafer or panel level.

In FIG. 3A, a release layer 302 is formed over a donor substrate 300. The layer 304 to be selectively transferred is formed over the release layer 302, such as by fabricating the layer 304 directly or blanket transferring the layer 304. In some embodiments, the selective transfer layer 304 may be a layer of IC components (e.g., IC dies, chiplets, interconnects, bridges, capacitors, transistors, and/or other semiconductor devices).

In FIG. 3B, the selective transfer layer 304 is diced over the donor substrate 300-without dicing through the donor substrate 300-to partially singulate the IC components 306 in the layer 304. In some embodiments, the release layer 302 may also be singulated (e.g., diced or etched) along with the transfer layer 306.

In FIG. 3C, the donor substrate 300 is diced into singulated donor dies 301 that each contain a subset of the IC components 306 from the original donor substrate 300. For example, each donor die 301 may include one or more IC components 306 from the layer 304 on the original donor substrate 300.

In FIG. 3D, either blanket laser exposure (as shown) or a selective laser release is performed on the donor release layer 302 to weaken the entire release layer 302 prior to the transfer (e.g., using IRJUV laser exposure or thermal techniques), thus partially releasing the IC components 306 from the donor dies 301.

In FIG. 3E, a release layer 312 is optionally formed over a receiver substrate 310 (e.g., in the event the selectively transferred IC components 306 will be subsequently debonded from the receiver substrate 310 after the transfer). Next, a bonding template 314 is formed on the surface of the receiver substrate 310 (e.g., above the release layer 312, if included). The bonding template 314 includes a pattern of bonding features or adhesive areas 314, such as mesas, that enable specific areas of a donor die 301 to be selectively transferred to the receiver substrate 310. In various embodiments, however, any suitable surface treatments or other techniques may be used to control the level of adhesion on different areas of the receiver substrate 310 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 3F, a bond head 320 is used to pick up one of the donor dies 301 and place it face down on the receiver substrate 310 such that the target IC components 306 on the donor die 301 are aligned with the corresponding bonding mesas 314 on the receiver substrate 310. The donor die 301 and receiver substrate 310 are then partially bonded together (e.g., die-to-wafer bond) with the target IC components 306 bonded to the receiver bonding mesas 314.

In FIG. 3G, the bond head 320 lifts up and mechanically separates the donor die 301 from the receiver substrate 310. At this point, the IC components 306 that were selectively bonded to the receiver 310 (e.g., via the bonding mesas 314) remain on the receiver 310 and are debonded/separated from the donor die 301 (e.g., die-to-wafer debond) due to the blanket weakening of the donor release layer 302. All other IC components 306 that were not bonded to the receiver substrate 310 remain on the donor die 301.

Alternatively, in some embodiments, instead of (or in addition to) performing blanket laser exposure in FIG. 3D, the target IC components 306 may be selectively released (e.g., as described with respect to FIG. 1F), or the donor release layer 302 and receiver bonding template 314 may be formed with materials having different bonding strengths such that the target IC components 306 will have a stronger bond to the receiver substrate 310 than the donor die 301.

In FIG. 3H and FIG. 3I, the bond head 320 steps and repeats. For example, the bond head 320 moves to a new position and repeats the process of FIG. 3F and FIG. 3G, respectively, to selectively transfer another group of IC components 306 from the donor die 301 to other areas of the receiver substrate 310.

The process may repeat in this manner until all IC components 306 on the donor die 301 have been transferred. At that point, the bond head 320 may pick up another donor die 301 and continue transferring IC components 306 from the new donor die 301 to the same or different receiver substrate 310.

After all transfers to the receiver substrate 310 are complete, the receiver 310 may be ready for continued processing, such as dielectric fill around the transferred IC components 306, planarization, selectively transferring or pick-and-place attaching additional IC dies or other IC components, via formation, formation of interconnect/metallization layers, attaching a structural substrate, debonding the receiver substrate (e.g., via the optional receiver release layer 312), and/or any other processing required for the finished product (e.g., an IC package).

Elements labeled with reference numerals in FIGS. 3A-I may be similar to those having similar reference numerals in FIGS. 1A-I. Further, it should be appreciated that the illustrated process flow for selective layer transfers is merely presented as an example and many other process variations are also possible, including, but not limited to, the process variations described throughout this disclosure.

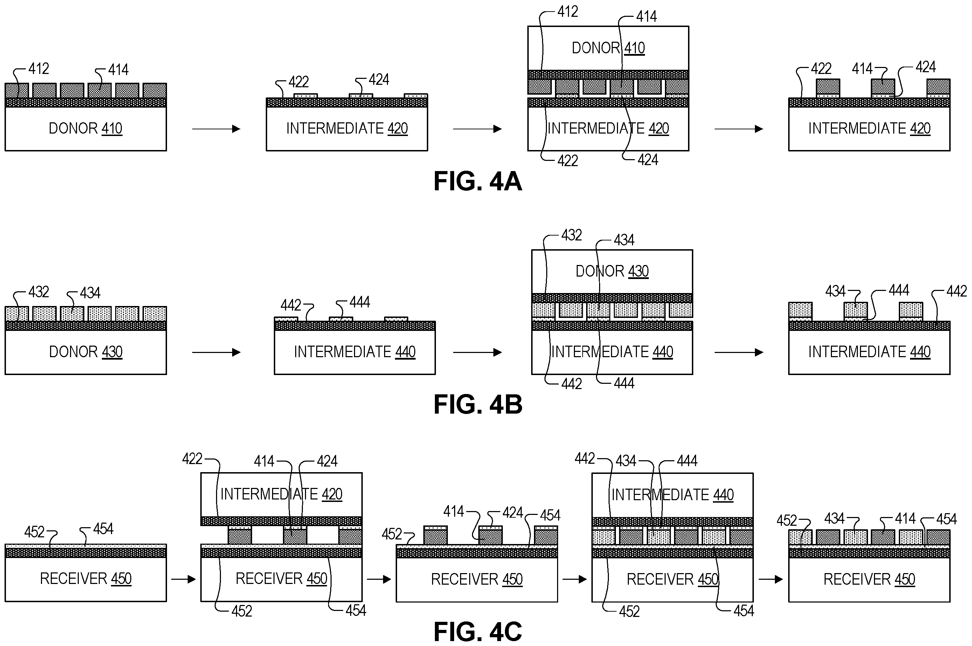

**FIGS. 4A-C** illustrate an example process flow for selective layer transfers from multiple donor substrates. In the illustrated example, integrated circuit (IC) components 414, 434 from multiple donor substrates 410, 430 are selectively transferred to a receiver substrate 450 using intermediate carrier substrates 420, 440. In some embodiments, the respective donors 410, 430 may have different types of IC components 414, 434, such as different types of IC dies or chiplets. In this manner, selective layer transfers can be used to transfer multiple types of IC components, such as different types of dies or chiplets, to the same receiver substrate 450. While the illustrated example depicts selective transfers from two types of donor substrates 410, 430 (e.g., with two types of types of IC components 414, 434), any number of donor substrates with any type of IC dies or other components are possible (including different die sizes).

In FIG. 4A, a layer of IC components 414 is selectively transferred from a first donor substrate 410 to an intermediate carrier substrate 420 (e.g., using any of the selective transfer flows described throughout the disclosure). For example, a release layer 412 is formed over the donor substrate 410. The layer 414 to be selectively transferred is then formed over the release layer 412 (e.g., by fabricating the layer 414 directly or blanket transferring the layer 414 from a wafer to the donor carrier 410) and diced into partially singulated IC components 414. Separately, a release layer 422 is formed over an intermediate carrier/receiver substrate 420, and a bonding template 424 is formed on the surface of the intermediate carrier 420 (e.g., above the release layer 422). The donor 410 and intermediate carrier 420 are then partially bonded together (e.g., with the target IC components 414 on the donor 410 bonded to the bonding features or adhesive areas 424 on the intermediate carrier 420). The donor 410 and intermediate carrier 420 are then debonded and separated from each other using any of the techniques described throughout this disclosure (e.g., selective release, blanket laser exposure, etc.). As a result, the target IC components 414 are debonded/-separated from the donor 410 and remain on the intermediate carrier 420.

In FIG. 4B, another layer of IC components 434 is selectively transferred from a second donor substrate 430 to another intermediate carrier substrate 440 (e.g., using any of the selective transfer flows described throughout the disclosure). For example, a release layer 432 is formed over the donor substrate 430. The layer 434 to be selectively transferred is then formed over the release layer 432 (e.g., by fabricating the layer 434 directly or blanket transferring the layer 434 from a wafer to the donor carrier 430) and diced into partially singulated IC components 434. Separately, a release layer 442 is formed over an intermediate carrier/receiver substrate 440, and a bonding template 444 is formed on the surface of the intermediate carrier 440 (e.g., above the release layer 442). The donor 430 and intermediate carrier 440 are then partially bonded together (e.g., with the target IC components 434 on the donor 430 bonded to the bonding features or adhesive areas 444 on the intermediate carrier 440). The donor 430 and intermediate carrier 440 are then debonded and separated from each other using any of the techniques described throughout this disclosure (e.g., selective release, blanket laser exposure, etc.). As a result, the target IC components 434 are debonded/-separated from the donor 430 and remain on the intermediate carrier 440.

In FIG. 4C, the IC components 414, 434 on both intermediate carriers 420, 440 are selectively transferred to a receiver substrate 450 (e.g., using any of the selective transfer flows described throughout the disclosure). For example, a release layer 452 is optionally formed over the receiver substrate 450 (e.g., in the event the selectively transferred IC components 414, 434 will be subsequently debonded from the receiver substrate 450 after the transfer). A bonding layer 454 (e.g., with adhesive areas / bonding features) is then formed on the surface of the receiver 450 (e.g., above the release layer 452, if included). Next, the IC components 414 on the first intermediate carrier 420 are selectively transferred to the receiver substrate 450 (e.g., using any of the selective transfer flows described throughout the disclosure). Finally, the IC components 434 on the second intermediate carrier 440 are selectively transferred to the receiver substrate 450 (e.g., using any of the selective transfer flows described throughout the disclosure).

Additional processing may then be performed on the receiver substrate 450, such as cleaning steps (e.g., removing the leftover bonding structures 424, 444 from the transferred IC components 414, 434), dielectric fill around the transferred IC components 414, 434, planarization, selectively transferring or pick-and-place attaching additional IC dies or other IC components, via formation, formation of interconnect/metallization layers, attaching a structural substrate, debonding the receiver substrate (e.g., via the optional receiver release layer 452), and/or any other processing required for the finished product (e.g., an IC package).

It should be appreciated that the illustrated process flow for selective layer transfers is merely presented as an example and many other process variations are also possible, including, but not limited to, the process variations described throughout this disclosure.

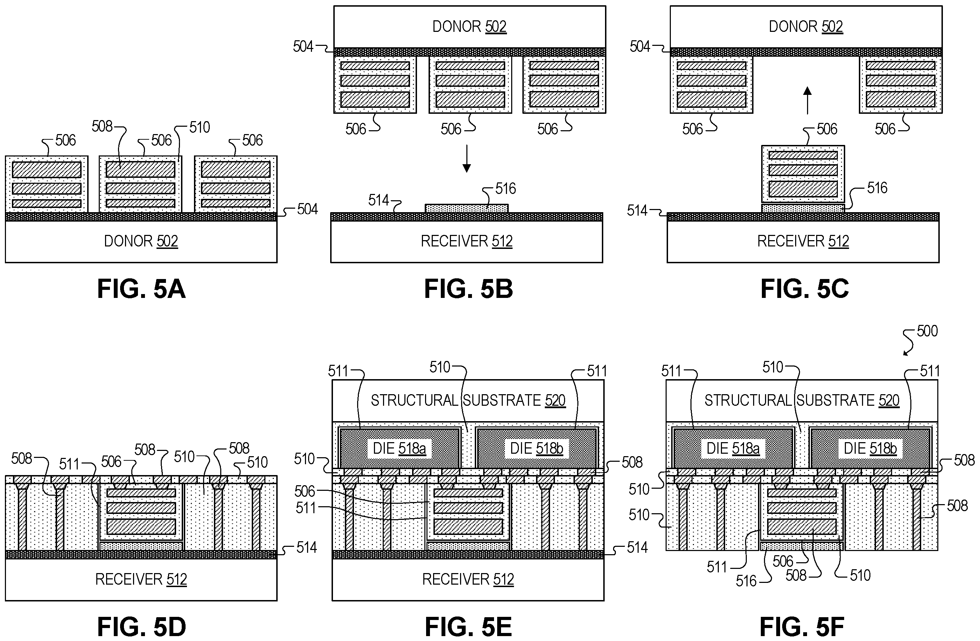

**FIGS. 5A-F** illustrate an example process flow for forming an integrated circuit (IC) package 500 with a selectively transferred passive interposer 506. Selective transfers can be used for a variety of applications, including transfers of active components (e.g., IC dies, transistors, diodes) and passive components (e.g., interconnects, metal-insulator-metal (MIM) chiplets, resistors, capacitors, inductors, transformers). In the illustrated example, the process flow is used to form an IC package 500 with a selectively-transferred low-cost passive interposer 506. For example, interposers 506 with high-density die-to-die (D2D) links 508 are created on a donor wafer 502 and then selectively transferred to a receiver wafer 512, which enables the same donor wafer 502 to be reused multiple times and amortizes the cost of the interconnect devices across multiple receiver wafers 512. In some embodiments, other components of the IC package 500 may also be selectively transferred, such as the IC dies 518a-b. Selective transfers can also be used for other applications, including, without limitation, transfers of photonic/optical components, and localized transfers of Group III-V semiconductors for radio frequency (RF) and high-power devices.

In FIG. 5A, repeated D2D interconnect patterns 506 are created on a release layer 504 of the donor substrate 502, and the resulting D2D interconnects are partially singulated (e.g., diced to, but not through, the donor substrate 502). The D2D interconnects 506 include high-density interconnect links 508 separated by dielectric layers 510.

In FIG. 5B, a transfer template 516 for a selective transfer is created on a release layer 514 of a receiver/carrier substrate 512. The transfer template 516 includes a dielectric bonding protrusion 516, referred to as a mesa, on the surface of the receiver substrate 512. In various embodiments, however, any suitable surface treatments or other techniques may be used to control the level of adhesion on different areas of the receiver substrate 512 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples. Further, in various embodiments, any number of buildup layers may be formed on the receiver substrate 512 prior to forming the templated connection pedestal or mesa 516 for the selective transfer.

The bonding mesa 516 is used to selectively transfer a D2D interconnect 506 from the donor 502 to the receiver 512 (e.g., using any of the selective transfer flows described throughout this disclosure). For example, the donor 502 and receiver 512 are aligned face to face, stacked, and then partially bonded together such that one of the D2D interconnects 506 on the donor 502 is bonded to the bonding mesa 516 on the receiver 512.

In FIG. 5C, the D2D interconnect 506 bonded to the receiver mesa 516 is debonded and/or released from the donor release layer 504 using any of the techniques described herein (e.g., selective release, blanket laser exposure, formation of bonds with strength disparities), and the donor 502 and receiver 512 are mechanically separated. As a result, the transferred D2D interconnect 506 is separated from the donor 502 and remains on the receiver 512.

In FIG. 5D, additional processing is performed to form the remaining interconnect, including dielectric (e.g., oxide) fill 510 and planarization, interconnect 508 patterning/metallization (e.g., formation of through-dielectric vias (TDVs) 508, top metal contacts 508 such as hybrid bonding pads, dielectric layers 510), and so forth.

Notably, since the D2D interposer 506 was selectively transferred while the surrounding dielectric layers 510 were fabricated directly on the receiver 512, there is a seam 511 between the transferred D2D interposer 506 and the surrounding layers 510, as shown in FIG. 5D. In general, this type of seam or transition may be present around selectively transferred components of any type since they are not formed contemporaneously with the surrounding layers.

In FIG. 5E, multiple IC dies 518a-b are attached to the top metal pads 508 (e.g., via hybrid bonding), the area around the dies 518a-b is filled with dielectric material 510 (e.g., oxide) and planarized, and a structural substrate 520 is attached (e.g., a structural silicon wafer).

The dies 518a-b may be attached using standard assembly techniques, such as pick and place, or using the selective transfer techniques described herein (e.g., similar to the transferred D2D interconnect 506).

If the dies 518a-b are attached using pick-and-place assembly, they are typically formed on a thick substrate for handling purposes and then subsequently thinned after the attach.

If the dies 518a-b are selectively transferred, however, they can be formed on-and transferred directly from-a very thin substrate. As a result, selectively transferring the dies 518a-b not only eliminates the need for post-attach thinning, it also enables the dies 518a-b to be much thinner than dies that are pick-and-place attached and subsequently thinned. Further, if the dies 518a-b are selectively transferred, there may be a seam 511 between the dies 518a-b and portions of the layers 510 surrounding the dies 518a-b, similar to the seam 511 shown around the transferred D2D interconnect 506, as described above. Moreover, because the dies 518a-b are selectively transferred, they can be different types of dies, formed on separate pieces of substrate material (e.g., separate wafers or panels) using separate processes, and then selectively transferred to the same layer of an IC device 500.

In FIG. 5F, the receiver 512 is debonded and released from the release layer 514 (e.g., using any of the techniques described herein, such as IR or UV laser ablation).

At this point, the IC package 500 may be complete, or alternatively, additional processing may be performed. For example, if the processing is performed at the wafer or panel level, the resulting IC packages 500 on the structural substrate 520 may be singulated.

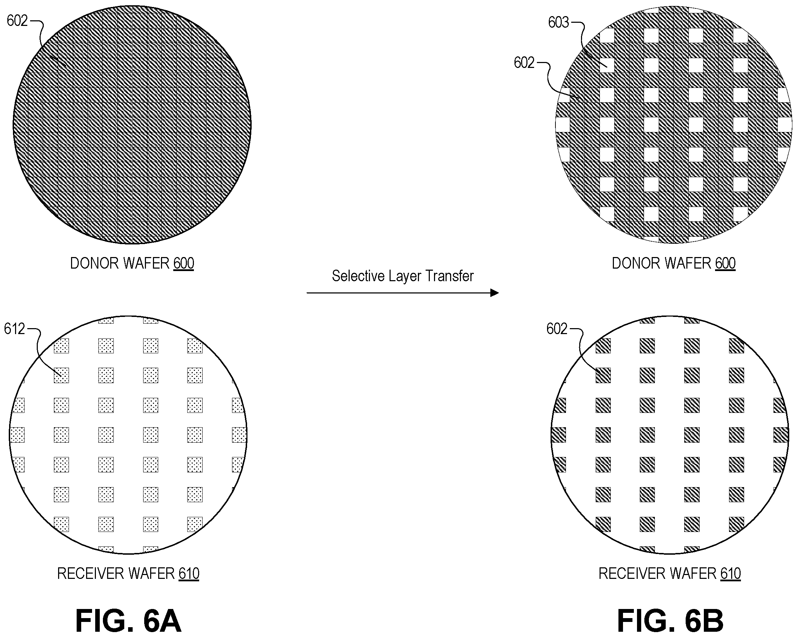

FIGS. 6A-B illustrate an example of a selective layer transfer between donor and receiver wafers 600, 610. In particular, FIG. 6A shows the wafers 600, 610 prior to the transfer, while FIG. 6B shows the wafers 600, 610 after the transfer. In the illustrated example, non-contiguous areas of the donor wafer 600 are selectively transferred to non-contiguous positions on the receiver wafer 610. In other embodiments, however, the target areas on the donor 600 and the destination areas on the receiver 610 may be partially contiguous or fully contiguous.

As shown in FIG. 6A, prior to the transfer, the donor wafer 600 includes a layer of integrated circuit (IC) components 602 (e.g., dies, chiplets, interconnects, capacitors, transistors, etc.), which may be partially singulated (e.g., diced down to, but not through, the underlying wafer 600). The receiver wafer 610 includes adhesive areas 612 patterned in non-contiguous positions on the surface (also referred to as a bonding template), which is where the target IC components 602 from the donor 600 will be transferred. In some embodiments, for example, the adhesive areas 612 may be raised structures or protrusions (referred to as "mesas") patterned on the surface of the receiver 612. Moreover, in some embodiments, the adhesive areas 612 on the receiver 610 may have a similar footprint as the target IC components 602 on the donor 600. In various embodiments, however, any suitable surface treatments or other techniques may be used to control the level of adhesion on different areas of the receiver substrate 610 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

As shown in FIG. 6B, after the transfer, the target IC components 602 have been transferred from the donor wafer 600 to the receiver wafer 610. As a result, the donor wafer 600 includes empty areas 603 where the transferred IC components 602 were located, while the receiver wafer 610 includes the transferred IC components 602 in the positions where the adhesive areas 612 were patterned. In particular, individual IC components 602 from the donor wafer 600 are now bonded to individual adhesive areas 612 on the receiver wafer 610.

While the illustrated example depicts a selective transfer between two wafers, selective transfers can be performed between panels or other substrates of any shape or size, including substrates with mismatched shapes and sizes.

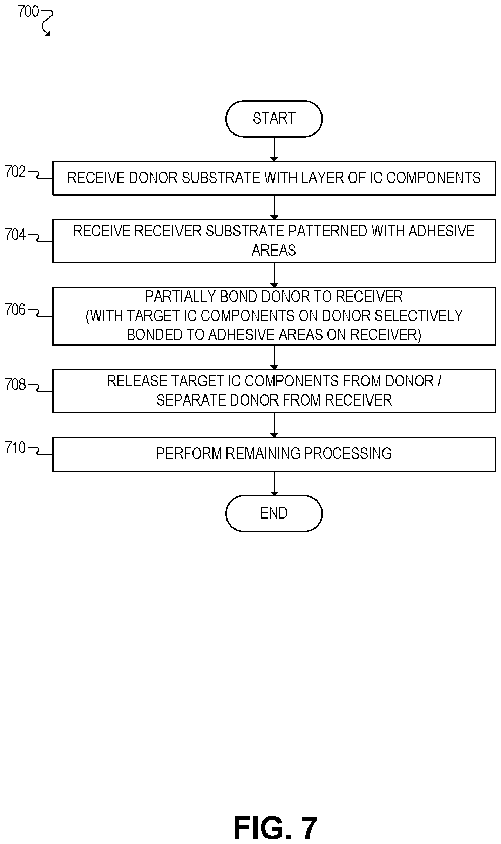

FIG. 7 illustrates a flowchart 700 for performing selective layer transfers. It will be appreciated in light of the present disclosure that the illustrated process flow is only one example methodology for performing selective layer transfers. Moreover, the steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 702 by receiving a first substrate with a layer of integrated circuit (IC) components, which may be referred to as the donor substrate. In some embodiments, the donor substrate may include a base substrate, a release layer over the base substrate, and a (partially singulated) layer of IC components over the release layer.

In some embodiments, the donor substrate may be formed by receiving the base substrate, forming the release layer over the base substrate, forming the layer of IC components over the release layer (e.g., by fabricating or transferring the layer of IC components over the release layer), and partially singulating the layer of IC components (e.g., by dicing through the layer of IC components without dicing through the base substrate).

In various embodiments, the layer of IC components may include one or more IC dies, interconnects, transistors, diodes, resistors, capacitors, inductors, transformers, optical components, and/or any other active or passive circuitry or components.

The base substrate may be made of one or more materials that include elements such as silicon (Si), oxygen (O), carbon (C), hydrogen (H), and/or Group III-V elements (e.g., aluminum (Al), gallium (Ga), indium (In), nitrogen (N), phosphorus (P), arsenic (As), antimony (Sb)), including, without limitation, silicon (Si), silicon dioxide (silica or $SiO_2$), silicon on insulator (SOI), quartz, glass, Group III-V materials (e.g., gallium nitride (GaN), aluminum gallium nitride (GaN), gallium arsenide (GaAs), indium gallium arsenide (InGaAs), indium phosphide (InP)), and epoxies/resins (e.g., IR or UV transparent epoxies).

The release layer may include one or more layers of varying materials depending on the type of release or debonding technology used. For example, for IR laser debonding, the release layer may include one or more layers of material(s) capable of absorbing and/or reflecting infrared (IR) electromagnetic radiation, such as a thin metal layer or multiple metal layers (e.g., aluminum (Al), tungsten (W), copper (Cu), titanium (Ti), titanium nitride (TiN), tantalum (Ta), tantalum nitride (TaN)). For UV laser debonding, the release layer may include one or more layers of material(s) capable of absorbing ultraviolet (UV) electromagnetic radiation (e.g., organic polymers such as polyimides). In some embodiments, the release layer may additionally or alternatively include one or more layers of dielectric materials to buffer laser ablation and thermal energy, control thin film interference or adhesion, and/or provide residual adhesion after other materials and/or layers in the release layers are weakened, removed, and/or ablated by a laser (e.g., silicon dioxide ($SiO_2$), silicon nitride ($Si_3N_4$), silicon oxynitride (SiON), silicon carbide (SiC), silicon carbon nitride (SiCN), silicon oxycarbon nitride (SiOCN), aluminum oxide ($Al_2O_3$), low-k dielectrics such as carbon-doped oxide (CDO) or porous silicon dioxide ($SiO_2$), titanium dioxide ($TiO_2$), tantalum oxide ($Ta_2O_5$)). Thus, in some embodiments, the release layer(s) may be made of one or more materials that include elements such as aluminum (Al), tungsten (W), copper (Cu), titanium (Ti), tantalum (Ta), silicon (Si), oxygen (O), nitrogen (N), hydrogen (H), and carbon (C), including, without limitation, any of the materials referenced above.

The flowchart then proceeds to block 704 to receive a second substrate with one or more adhesive areas, which may be referred to as the receiver substrate. In some embodiments, the receiver substrate may include a base substrate patterned with one or more adhesive areas on the surface, such as a layer of raised bonding structures or "mesas" over the base substrate. The receiver substrate may also optionally include a release layer over the base substrate (e.g., to enable the base substrate to be subsequently debonded after the transfer) and/or one or more additional buildup layers and/or IC components.

In some embodiments, the receiver substrate may be formed by receiving the base substrate, optionally forming a release layer over the base substrate, optionally forming additional buildup layers and/or IC components over the base substrate (e.g., over the optional release layer, if included), and forming the adhesive areas (e.g., bonding structures) on the surface of the receiver substrate (e.g., over the previously referenced layers, if included). In some embodiments, the base substrate and the optional release layer of the receiver may be made of any of the materials referenced above for the base substrate and the release layer of the donor, respectively.

In some embodiments, the adhesive areas may include mesa structures with similar footprints as the corresponding IC components to be transferred from the donor (although, in some cases, the mesas may be slightly larger or smaller than the IC components to accommodate alignment and manufacturing tolerances). The mesa structures may be made of varying materials depending on the type of bond and/or whether electrical connections are needed through the bond interface for the subsequently bonded IC components (e.g., dielectric material, metal, or both). For example, the mesa structures may include blanket dielectric structures with no conductive contacts (e.g., for dielectric-to-dielectric bonds), dielectric structures with conductive contacts (e.g., for hybrid dielectric and metal bonds), and/or conductive contacts by themselves (e.g., for metal-to-metal bonds). Thus, in some embodiments, the mesa structures may be made of one or more materials that include elements such as silicon (Si), oxygen (O), hydrogen (H), nitrogen (N), carbon ©, aluminum (Al), tungsten (W), copper (Cu), titanium (Ti), tantalum (Ta), including, without limitation, inorganic dielectrics such as silicon dioxide ($SiO_2$), silicon nitride ($Si_3N_4$), and/or silicon carbon nitride (SiCN), organic dielectrics such as photoresists and adhesives, and/or conductive materials such as metals and alloys (e.g., any of the foregoing metal elements and/or compounds/alloys thereof).

In various embodiments, however, any suitable technique(s) may be used to control the level of adhesion on different areas of the receiver substrate. For example, a variety of surface treatments (e.g., lithographically or additively manufactured) can be used to enhance and/or reduce adhesion in select areas of the receiver substrate, including, without limitation, modifying the surface topography (e.g., raised vs. recessed areas, smooth vs. rough areas), use of materials with high and/or low adhesion (e.g., forming layers with adhesive and non-adhesive materials in select areas), treatments using hydrophobic materials and/or self-assembled monolayers (SAMs), and/or surface activation techniques (e.g., plasma or wet activation), among other examples.

For example, the surface topography of the receiver substrate may be modified (e.g., using techniques such as deposition, lithography, etching, roughening) to form areas with different levels of adhesion, such as raised (e.g., adhesive) and recessed (e.g., non-adhesive) areas, smooth (e.g., adhesive) and rough (e.g., non-adhesive) areas, etc.

As another example, the surface of the receiver substrate may be patterned with materials having high and/or low adhesion in select areas. For example, a layer patterned with different areas of adhesive and non-adhesive materials may be formed on the receiver substrate. In some embodiments, the adhesive material may include silicon dioxide ($SiO_2$) or silicon carbon nitride (SiCN) to promote strong oxide fusion bonds, silicon carbide (SiC) to provide lower thermal contact resistance compared to $SiO_2$ or SiCN, and/or metal to form electrical connections. Further, in some embodiments, the non-adhesive material may include silicon nitride ($Si_3N_4$) to form weak or no bonds.

As another example, treatments using hydrophobic materials and/or self-assembled monolayers (SAMs) may be used to enhance and/or reduce adhesion in select areas of the receiver substrate (e.g., using a SAM treatment to create monolayers with high and/or low adhesion in select areas). In some embodiments, the hydrophobic material may include a SAM material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). However, non-SAM based materials or films may also be used. In some embodiments, the hydrophobic material may include a thin polymer film such as a siloxane (e.g., PDMS and derivatives, HMDSO), a silazane (HMDS), a polyolefin (e.g., PP), or a fluorinated polymer (e.g., PTFE, PFPE, PFDA, C4F8 plasma polymerized films, etc.). Other hydrophobic materials may be used in other embodiments.

As another example, surface activation techniques may be used to enhance and/or reduce adhesion in select areas of the receiver substrate, including, without limitation, plasma or wet activation.

The flowchart then proceeds to block 706 to partially bond the donor substrate to the receiver substrate (e.g., face to face), such that one or more target IC components on the donor substrate are selectively bonded to the one or more adhesive areas on the receiver substrate. The donor and receiver substrates may be partially bonded using any suitable bonding techniques, including, without limitation, hybrid bonding, fusion bonding, and/or adhesive bonding.

The flowchart then proceeds to block 708 to release the target IC components from the donor substrate and separate the donor substrate from the receiver substrate. In this manner, when the donor and receiver substrates are separated, the target IC components are separated from the donor substrate and remain on the receiver substrate.

In some embodiments, the donor and receiver substates may be debonded/separated from each other by releasing, at least partially, the target IC components from the release layer of the donor substrate and then mechanically separating the donor and receiver substrates. For example, in some embodiments, the target IC components may be fully released from the donor substrate by selectively debonding them from the donor release layer using a laser (e.g., an IR or UV laser), or alternatively, the target IC components may be partially released from the donor substrate by weakening the donor release layer using a laser (e.g., an IR or UV laser). After fully or partially releasing the target IC components from the donor, the donor and receiver substrates are mechanically separated, and post separation, the target IC components remain bonded to the receiver and are no longer on the donor.

Alternatively, or additionally, the donor release layer and the receiver bonding structures may be formed with respective materials that have disparate bond strengths-such that the target IC components have a stronger bond to the receiver than the donor-thus causing the target IC components to debond from the donor and remain on the receiver when the donor and receiver are mechanically separated.

The flowchart then proceeds to block 710 to perform any remaining processing, such as dielectric filling and planarization, attaching additional IC dies or components (e.g., via selective transfers or pick-and-place assembly), forming interconnects (e.g., vias, traces), attaching a structural substrate, debonding the receiver base substrate (e.g., via the optional receiver release layer), and/or any other processing required for the finished product (e.g., an IC package, device, system, etc.).

The completed product may include a variety of components and circuitry (some of which may have been selectively transferred), including electrical components (e.g., electronic integrated circuits (EICs), processors, XPUs, controllers, memory), optical components (e.g., optical interfaces, photonic integrated circuits (PICs), optical connectors, fibers), and/or radio frequency (RF) or high-voltage components (e.g., high-voltage electrostatic discharge (ESD) devices, power amplifiers (PAs), low noise amplifiers (LNAs), voltage controlled oscillators (VCOs), surface acoustic wave (SAW) / bulk acoustic wave (BAW) devices or filters, bandpass filters (BPFs), intermediate-frequency (IF) amplifiers, frequency synthesizers, mixers, RF digital-to-analog converters (DACs), RF analog-to-digital converters (ADCs), thick gate oxide devices, Group III-V devices/chiplets, passive RF devices such as interconnects, antennas, and inductors).

Further, in some embodiments, the resulting IC package or product may be electrically coupled to a circuit board and/or incorporated into an electronic device or system (e.g., with other electronic components).

At this point, the flowchart may be complete. In some embodiments, however, the flowchart may restart and/or certain blocks may be repeated. For example, in some embodiments, the flowchart may restart at block 702 to continue performing selective transfers.

*Blanket Wafer Laser Exposure For Fast Selective Transfers*

As discussed above, transfers of selective areas or dies from a donor substrate to a receiver substrate addresses the shortcomings of existing approaches (e.g., full layer transfers, monolithic IC fabrication, chiplet pick-and-place assembly) and enables the donor substrate to be reused multiple times. For example, a full wafer layer transfer requires removal of the unneeded areas after the transfer, which results in higher costs and lower performance. Moreover, pick-and-place die bonding has lower throughput as dies become smaller and more dies are attached, and the ability to scale down die area and thickness is limited, as dies/chiplets with certain design parameters cannot be attached using pick-and-place (e.g., high-aspect-ratio dies, sub-millimeter dies, thin dies/layers).

While selective transfers alleviate the foregoing limitations of existing approaches, they also face their own unique challenges. For example, in some cases, selective debonding (e.g., releasing only selective areas from the donor wafer using laser debond technology) can be slow, particularly as the transferred areas decrease in size (e.g., die size < 1 mm$^2$), and the percentage of the donor wafer transferred to each receiver wafer (%xfer) becomes lower.

Another challenge involves handling wafers for selective debond processing after bonding the donor and the receiver, which requires an in-plane offset between the wafers for all transfers after the first receiver wafer. Automated handling systems and front opening unified pods (FOUPs) that hold wafers during transport in a semiconductor foundry cannot accept these non-circular offset-bonded wafer pairs. Moreover, no existing equipment or tool is capable of performing selective debonding for wafer pairs, and even if one were developed, there would be no way to transfer offset-bonded wafer pairs between bonding and selective debonding tools. Solving the offset-bonded wafer problem requires integrating bonding, selective layer release, and debonding into a single tool, which is complicated and challenging and also requires developing new wafer handling robotics to handle offset-bonding wafers in the tool, which is even more challenging.

Accordingly, this disclosure presents embodiments of fast selective layer transfers using blanket wafer laser exposure, including processes, thin film architectures, and tooling. For example, thin structured films are fabricated below the selectively transferred layers or dies to enable blanket laser exposure of the full wafer to be performed only once followed by selective transfer of the areas from the donor wafer with a bond/debond process for each receiver wafer. This eliminates the slow process of selectively debonding small areas of the wafer for each transfer to a receiver wafer. Further, this solution leverages a novel bond/debond tool that eliminates any need to handle non-circular offset-bonded wafer pairs.

The described solution provides various advantages. For example, this solution eliminates the slow process of selectively debonding small areas of the wafer for each transfer to a receiver wafer-instead, only one blanket laser exposure is required for each donor wafer using standard laser debond tools. Selective transfer from the donor to each receiver wafer is controlled by selective bonding to patterned adhesive areas (e.g., mesas or other adhesive mechanisms) on the receiver wafer, which is a fast full-wafer process. The bond/debond tool eliminates any need for handling non-circular offset-bonded wafer pairs, as receiver wafers can be bonded to the pre-exposed donor wafer and then immediately debonded with selective transfer in the same module. Further, the thin film release layer architecture can be designed to protect die edge and corners from shockwave damage.

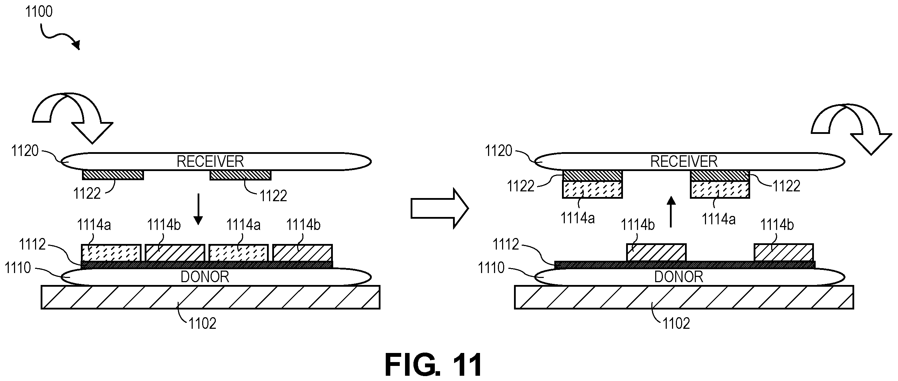

**FIGS. 8A-E** illustrate an example process flow for selective transfers using blanket wafer laser exposure. In the illustrated example, blanket laser exposure of the donor wafer 800 is performed once (e.g., in a standard laser debond tool) to weaken the release layer 802, followed by a selective bond/debond of the donor and receiver wafers 800, 810 (e.g., using the selective bond/-debond tool 1100 of FIG. 11) .

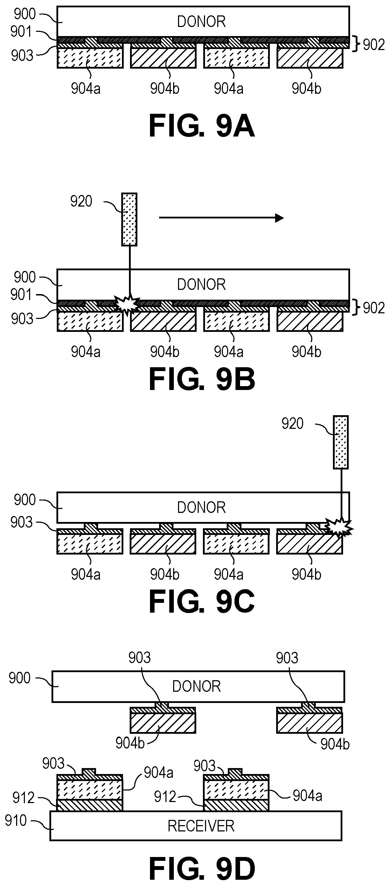

In FIG. 8A, a donor wafer 800 is formed with selective transfer layers 804a-b on a release layer 802. The release layer 802 may include one or more thin film layers that enable laser debonding of the selective transfer layers 804a-b, such as a thin metal layer capable of absorbing infrared (IR) light, and/or structured dielectric and metal layers (e.g., similar to release layers 902, 1002 of FIGS. 9-10). In FIGS. 8A-E, a continuous blanket release layer 802 is shown, but in other embodiments, the release layer 802 may include multiple dielectric and metal layers patterned with streets etched through some or all of those layers between the areas 804a-b to be selectively transferred (e.g., as shown in FIGS. 9-10).

The selective transfer layers 804a-b may include any combination of one or more layers to be selectively transferred. In the illustrated example, the selective transfer layers 804a-b include multiple IC components 804a-b, such as dies or chiplets, that will be transferred to two different receiver wafers 810a-b across two selective transfers (e.g., %xfer = 50% per transfer). In particular, a first set of IC components 804a will be transferred to a first receiver 810a, and a second set of IC components 804b will be transferred to a second receiver 810b. In some embodiments, for example, the two sets of IC components 804a-b may be the same type of die, or different types of dies, transferred to different receivers 810a-b via separate transfers.

In FIG. 8B, a blanket scan with laser exposure is performed on the donor wafer 800 using a laser debond tool 820, which removes portions of the release layer 802 and/or weakens its structural integrity, while still providing residual adhesion to the dies/layers 804a-b that will be selectively transferred.

In FIG. 8C, the donor wafer 800 is partially or selectively bonded to a first receiver wafer 810a with templated adhesive areas 812 on its surface (e.g., using bond/debond tool 1100). For example, the target IC components 804a for the first transfer from the donor 810a are bonded to the adhesive areas 812 on the receiver 810a, while the other IC components 804b remain unbonded. In the illustrated embodiment, the adhesive areas 812 are raised bonding mesas. In other embodiments, however, the adhesive areas 812 may be formed using any suitable surface treatments or other techniques to control the level of adhesion in different areas of the receiver substrates 810a-b, including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 8D, the donor and receiver wafers 800, 810a are mechanically separated and debonded (e.g., using bond/debond tool 1100). In particular, due to the weakened release layer 802, when the donor and receiver wafers 800, 810a are mechanically separated, the target IC components 804a are debonded from the donor 800 and remain on the receiver 810a. This is because the bond to the receiver 810a is stronger than the residual adhesion to the donor 800, as the bond energy provided by the mesas 812 is greater than the residual adhesion energy provided by the weakened release layer 802.

In FIG. 8E, the first receiver wafer 810a is transferred out and a second receiver wafer 810b is transferred in for the next selective transfer, and the steps of FIG. 8C and FIG. 8D are repeated to transfer another set of IC components 804b to the new receiver 810b (e.g., by selectively bonding/debonding the donor 800 and receiver 810b). The steps of FIG. 8C and FIG. 8D may be repeated in this manner for as many receiver wafers 810 as needed.

**FIGS. 9A-D** illustrate an example process flow for selective transfers using a structured release layer 902 with residual adhesion anchors 903. In general, the residual adhesion remaining in the release layer 902 after the blanket laser release process can be controlled by adjusting the pitch and pulse energy of the laser during exposure, but that approach can be unreliable across variations in products and within wafer and wafer-to-wafer variations. As a result, some of the selective transfer areas may inadvertently debond from the donor wafer during or after performing the blanket laser release (e.g., during subsequent handling). Accordingly, in the illustrated example, the laser release layer 902 is patterned with dielectric anchors 903 that do not absorb the laser 920, which are left behind after the blanket laser release to maintain a bond between the dies 904a-b (or other components/areas/layers) and the donor wafer 900 over a relatively small percentage of the die area. In this manner, the residual anchors 903 provide sufficient adhesion to the dies 904a-b during transfer of the donor wafer 900 to the bond/debond tool 1100, yet the residual adhesion energy will still be less than the bond energy to the receiver wafer 910, thus enabling the dies 904a-b to be selectively transferred to the templated receiver wafer 910 using the bond/debond tool 1100.

In FIG. 9A, a donor wafer 900 is formed with a layer of dies 904a-b on a structured release layer 902. The structured release layer 902 includes a laser absorption layer 901 patterned with dielectric anchors 903 that are transparent to the laser 920. In some embodiments, the laser absorption layer 901 may include a thin metal layer capable of absorbing infrared (IR) light, and the dielectric anchors 903 may include one or more layers of dielectric bonding film that are transparent to IR light. Moreover, the dielectric anchors 903 are patterned through the laser absorption layer 901 to provide adhesion between the donor wafer 900 and the dies 904a-b.

In FIG. 9B, a blanket scan with laser exposure is performed on the donor wafer 900 using a laser debond tool 920, which removes or ablates the laser absorption layer 901 while leaving the dielectric anchors 903 intact, as shown in FIG. 9C.

In FIG. 9C, the dielectric anchors 903 remaining after the blanket laser exposure are designed with a low percentage of area relative to the dies 904a-b, which causes the anchors 903 to hold the dies 904a-b to the donor 900 with low residual adhesion.

In FIG. 9D, the donor wafer 900 is selectively bonded to, and then debonded from, a receiver wafer 910 patterned with bonding mesas 912 (or other types of adhesive areas), which causes certain dies 904a to bond to the receiver mesas 912 and fully debond from the patterned donor anchors 903, thus selectively transferring the dies 904a from the donor 900 to the receiver 910.

After being debonded from the donor 900, the selectively transferred dies 904a may retain some or all of the residue above them from the patterned release layer anchors 903. For example, as shown in FIG. 9D, all of the bonding dielectric in the patterned anchors 903 above the transferred dies 904a debonds from the donor 900 and remains on the selectively transferred dies 904a. In this manner, the transferred dies 904a are fully covered by bonding dielectric from the patterned anchor structures 903 above them.

In other cases, however, some of the bonding dielectric from the anchors 903 may remain on the donor wafer 900 (e.g., the smaller portion anchored to the donor 900) while the rest of the bonding dielectric may remain on the selectively transferred dies 904a, thus forming a negative pattern of anchors in the bonding dielectric on the transferred dies 904a (not shown). In these cases, a layer of dielectric residue from the anchors 903 remains on the transferred dies 904a, but the dielectric residue may only partially cover each die 904a, as some of the dielectric residue may remain on the donor 900.

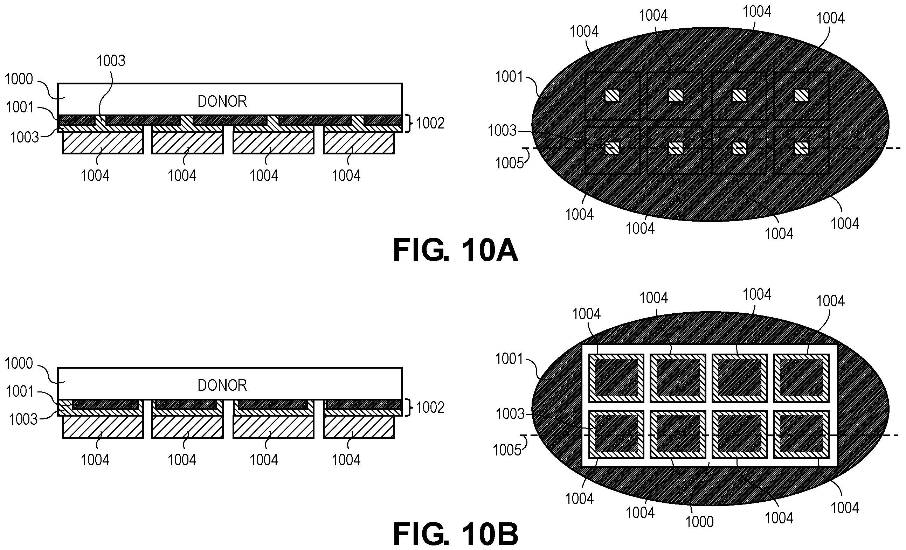

For example, with respect to the anchor pattern shown in FIG. 10A (which is the same anchor pattern as this example), the anchor layer 1003 is bonded to the entire surface of the dies 1004, but the anchor layer 1003 is only bonded to the donor 1000 via small anchor structures positioned near the center of the dies 1004. After a transfer, in some cases, the entire anchor structure 1003 above the transferred dies 1004 may debond from the donor 1000 and remain on the dies 1004, thus covering the entire surface of the transferred dies 1004. Alternatively, the small anchor structures in the anchor layer 1003 may remain on the donor 1000, while the rest of the anchor layer 1003 may remain on the transferred dies 1004. Thus, the layer of dielectric residue 1003 may partially cover the surface of the transferred dies 1004, except for an area near the center of the dies 1004, as that portion of the dielectric residue 1003 may remain on the donor 1000. For example, from a plan view, the dielectric residue 1003 on a transferred die 1004 may have a similar footprint as the die 1004 but with a hole near the center (e.g., the inverse pattern of the anchors 1003 shown in the plan view of FIG. 10A).

With respect to the anchor pattern shown in FIG. 10B, the anchor layer 1003 is bonded to the entire surface of the dies 1004, but the anchor layer 1003 is only bonded to the donor 1000 via anchor structures positioned along the edges of the dies 1004. After a transfer, in some cases, the entire anchor structure 1003 above the transferred dies 1004 may debond from the donor 1000 and remain on the dies 1004, thus covering the entire surface of the transferred dies 1004. Alternatively, the portions of the anchor layer 1003 along the die edges may remain on the donor 1000, while the rest of the anchor layer 1003 may remain on the transferred dies 1004. Thus, the layer of dielectric residue 1003 may partially cover the surface of the transferred dies 1004, except for the edges of the dies 1004, as that portion of the dielectric residue 1003 may remain on the donor 1000. For example, from a plan view, the dielectric residue 1003 on a transferred die 1004 may be roughly centered over the die 1004, but with a slightly smaller footprint that may not cover the edges of the die 1004, as that portion of the dielectric residue 1003 may remain on the donor 1000 (e.g., the inverse pattern of the anchors 1003 shown in the plan view of FIG. 10B).

Turning back to FIG. 9D, this dielectric residue 903 can potentially be removed from the transferred dies 904a using lithography and etch processing, but that adds full wafer processing costs to remove dielectric residue 903 from small areas of the wafer. Thus, in some embodiments, the dielectric residue 903 may simply be left on the dies 904a and the remaining processing may be performed as it normally would.

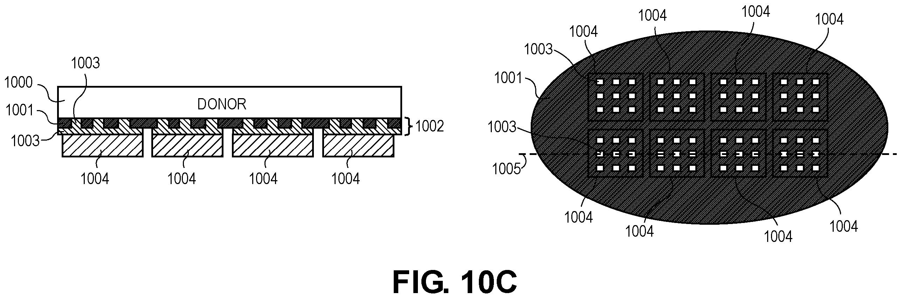

**FIGS. 10A-C** illustrate examples of patterned release layer structures 1002 to control residual adhesion using anchors 1003. In particular, FIGS. 10A, 10B, and 10C depict cross-section and plan views of a donor wafer 1000 with dielectric anchors 1003 patterned in the release layer 1002 at the center of the dies 1004, along edges of the dies 1004, and in an array throughout the dies 1004, respectively. In the illustrated examples, the cross-section views are based on the cutting plane 1005 shown in the plan views.

In FIG. 10A, the release layer 1002 on the donor wafer 1000 includes a laser absorption layer 1001 patterned with dielectric anchors 1003 that attach to the donor 1000 at the center of the dies 1004. In various embodiments, the portion of the anchors 1003 at the center of the dies 1004 can be any shape (e.g., square, rectangle, circle, etc.).

In FIG. 10B, the release layer 1002 includes a laser absorption layer 1001 patterned with dielectric anchors 1003 that attach to the donor 1000 along the edges of the dies 1004 to protect the edges from shockwave damage. For example, the dielectric anchors 1003 help protect the edges of the dies 1004 from mechanical damage due to laser induced shockwaves, which can potentially chip the die edges and corners. The width and total area of the anchors 1003 can be tuned to balance the residual adhesion for optimum selective transfer performance and reliability. In some embodiments, for example, each anchor 1003 may be a meandering spring (as viewed from the top) which is freestanding everywhere except at its beginning (e.g., where the anchor 1003 connects to donor wafer 1000) and end (e.g., where the anchor 1003 connects to the die 1004) to increase compliance and reduce potential damage to the dies 1004 upon release.

In FIG. 10C, the release layer 1002 on the donor wafer 1000 includes a laser absorption layer 1001 patterned with an array of dielectric anchors 1003 that attach to the donor 1000 in an array of positions on each die 1004. In various embodiments, the anchor array 1003 (and/or the individual anchors within the array 1003) may have any number of anchors, shape, size, or total area within each die 1004 (or other selectively transferred areas 1004), and the anchor pattern can include any combination of structures, such as those in FIGS. 10A-B.

FIG. 11 illustrates an example embodiment of a bond/debond tool 1100 designed for selective transfers in accordance with certain embodiments. A traditional wafer-to-wafer bonding tool receives two wafers, stacks them one on top of the other, bonds them, and then transfers out a single bonded wafer pair. For a selective transfer, however, the bonded wafer pair needs to be debonded to complete the transfer, which means it would need to be transferred to a separate debonding tool. However, no existing debonding tools are capable of selectively debonding a pair of donor and receiver wafers for a selective transfer. Moreover, selective transfers typically require the donor and receiver wafers to be bonded at an offset for all transfers from the same donor wafer beyond the first transfer (e.g., for transfers from the donor to the 2nd through nth receivers). As a result, an offset-bonded wafer pair would need to be transferred out of the traditional bonding tool to the (non-existent) debonding tool. However, existing wafer handling systems are unable to handle non-circular offset-bonded wafer pairs. Accordingly, in the illustrated example, the bond/-debond tool 1100 is designed to perform the bond and debond steps for a selective transfer in the same module, thus avoiding the need to transfer an offset-bonded wafer pair to a separate and non-existent debonding tool. For example, the bond/debond tool 1100 performs a selective transfer from a donor wafer 1110 to a receiver wafer 1120 by bonding the receiver 1120 to the donor 1110 and then immediately debonding the wafers 1110, 1120, as described below.

In the illustrated embodiment, the bond/debond tool 1100 brings in the donor and receiver wafers 1110, 1120 separately (e.g., via robotic arms) and holds the donor wafer 1110 in place on its own wafer chuck 1102, selectively bonds the wafers 1110, 1120 (e.g., bonding the donor dies 1114a to the receiver mesas 1122 (or other types of adhesive areas)), and then immediately removes the receiver wafer 1120 after bonding (e.g., via vacuum lift-off), thus debonding the receiver 1120 from the donor 1110. In this manner, the bonding and debonding functions are integrated into a single module.

Moreover, while holding the donor wafer 1110 in place on chuck 1102, receiver wafers 1120 are sequentially transferred in, bonded, mechanically separated, and then transferred out. In this manner, multiple receiver wafers 1120 can be cycled through the bond/debond process while the donor wafer 1110 remains in the module.

Further, since the bond/debond tool 1100 performs the bond and debond functions in the same module and then transfers out the receiver wafer 1120 by itself, no offset-bonded wafer pairs are transferred, thus eliminating the need to modify the automated handling systems to support offset-bonded wafer pairs.

In the illustrated example, the donor wafer 1110, release layer 1112, dies 1114a-b, receiver wafer 1120, and bonding mesas 1122 may be similar to elements from other figures with similar names. Moreover, it should be appreciated that the illustrated bond/debond tool 1100 for selective transfers is merely presented as an example and numerous variations are possible. In some embodiments, for example, the receiver wafer 1120 may be held in place on its own wafer chuck during the bonding process. Moreover, any type of bonding may be used to bond the donor and receiver wafers 1110, 1120 (e.g., hybrid bonding, fusion bonding, thermal/pressurized bonding). Further, after the wafers 1110, 1120 are bonded, the receiver wafer 1120 may be mechanically separated from the donor wafer using any suitable technique (e.g., vacuum lift off).

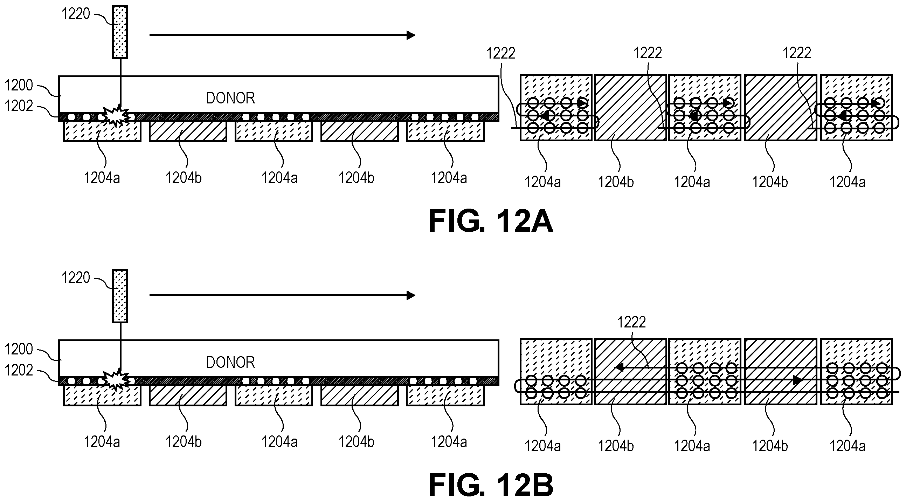

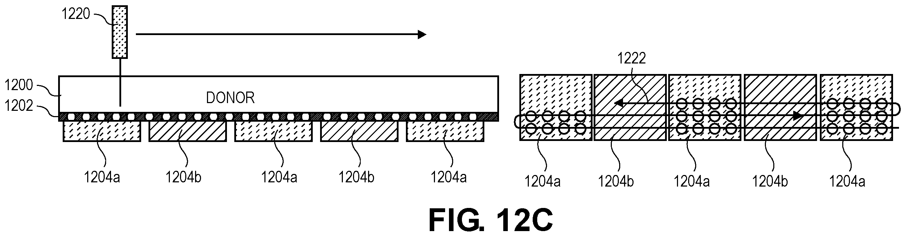

**FIGS. 12A-C** illustrate various laser release techniques for selective transfers. In particular, FIGS. 12A, 12B, and 12C depict cross-section and plan views of a donor wafer 1200 while performing selective scan and laser exposure, blanket scan and selective laser exposure, and blanket scan and laser exposure techniques, respectively.

In the illustrated examples, the various laser release techniques are performed on a donor wafer 1200 with a layer of integrated circuit (IC) dies 1204a-b over a release layer 1202.

In FIG. 12A, the laser release is performed using a selective scan and laser exposure technique. As depicted by the laser path 1222, the donor wafer 1200 is selectively scanned and exposed to the laser 1220 (e.g., using a galvanometer) over the areas of the release layer 1202 that are bonded to the target dies 1204a to be transferred, thus removing or weakening those areas of the release layer 1202 for the subsequent transfer. This approach is relatively slow, as it has a very short scan length and requires numerous direction changes per die 1204a, with each direction change taking approximately 1 millisecond (ms), and many steppings between the selective release areas. As a result, the average scanning speed gets slower as the dies 1204a-b become smaller. Moreover, this selective release process must be repeated on the donor wafer 1200 for each transfer to a receiver wafer. This approach also requires complicated integration of bonding, selective laser release, and debonding with transfer of offset-bonded wafer pairs.

In FIG. 12B, the laser release is performed using a blanket scan and selective laser exposure technique. As depicted by the laser path 1222, the entire donor wafer 1200 is blanket scanned but only selectively exposed to the laser 1220 over areas of the release layer 1202 that are bonded to the target dies 1204a. For example, during the blanket scan, the laser 1220 may be exposed while scanning over the target dies 1204a and shuttered while scanning over the unselected dies 1204b. This approach is faster than the one from FIG. 12A, as fewer direction changes are required since the entire donor wafer 1200 is scanned. However, even though the entire donor wafer 1200 is scanned, only the target dies 1204a are released during the scan. As a result, this approach requires a full donor wafer scan for each transfer to a receiver wafer. The transfer time per die for this approach can be computed as follows: *transfer time per die =*

$$\frac{blanket\ exposure\ time}{\%xfer}$$

, where '%xfer' represents the percentage of dies (or other selectively transferred components) on the donor wafer that are transferred to each receiver wafer. The transfer time per die increases as the transfer percentage (%xfer) decreases. For example, if only 1 out of every 10 dies on the donor are transferred each time, the transfer percentage (%xfer) is 10%, which increases the transfer time per die since more transfers are required. This approach also requires complicated integration of bonding, selective laser release, and debonding with transfer of offset-bonded wafer pairs.

In FIG. 12C, the laser release is performed using a blanket scan and laser exposure technique. As depicted by the laser path 1222, the entire donor wafer 1200 is blanket scanned and exposed to the laser 1220, thus weakening the entire release layer 1202 while still providing residual adhesion to the dies 1204a-b. In this manner, only one blanket wafer scan/exposure is required for each donor wafer 1200. As a result, this approach is significantly faster than those of FIGS. 12A-B. As an example, for a die size of 1 mm², this approach may take approximately 3.6 ms per die. The laser release can be performed using standard laser debond tooling, while the subsequent bond/debond with receiver wafers can be performed using bond/debond tool 1100, which provides a much simpler configuration compared to the other approaches and does not require offset-bonded wafer handling.

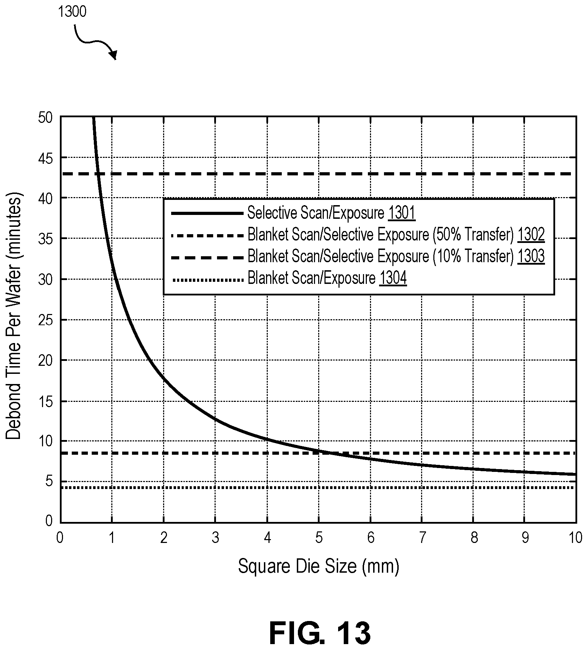

**FIG. 13** illustrates a graph 1300 of the laser debonding time for selective transfers using various laser debonding techniques. In particular, graph 1300 shows the laser debond time per donor wafer (minutes) based on the square die size (mm) (e.g., the length/width of a square die, such as 1x1 mm, 2x2 mm, etc.). The laser debond time represents the total time to debond, or partially release, all dies (or other components) on a donor wafer using an IR debond laser at a 40 $\mu$m pitch

(e.g., the total laser release process scan time per donor wafer, exclusive of the time required for the bond/separate steps with the receiver wafers). The time values will differ for other laser debond tools, such as a UV debonder, but the relative comparison applies generally for all laser debond tools.

For selective scan/exposure 1301, the debond time per donor wafer increases exponentially as the die size decreases and becomes less practical for dies smaller than 3 mm$^2$. For example, the debond time ranges from 6-13 minutes for a die size of 3-10 mm$^2$, but the debond time increases to over 30 minutes as the die size approaches 1 mm$^2$.

For blanket scan/selective exposure 1302, 1303, the debond times per donor wafer are shown for transfer percentages of 50% and 10%, respectively. The process time 1302 is reasonable for a transfer percentage of 50% (~8.5 minutes), but as the transfer percentage reduces to 10%, the process time 1303 for a full donor wafer increases to over 40 minutes.

For blanket scan/exposure 1304, the process time is independent of the die size and transfer percentage because, regardless of those values, only one full wafer blanket scan/exposure is required. As a result, this is the fastest approach and requires less than 5 minutes per donor wafer.

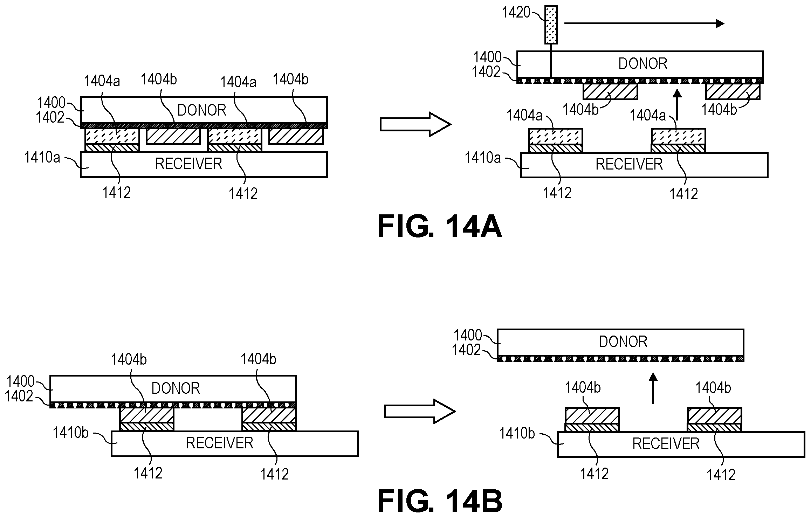

**FIGS. 14A-B** illustrate a selective transfer process flow for avoiding contact between the donor wafer surface and wafer chuck during a blanket laser release. For example, if a blanket laser release is performed on a donor wafer prior to being bonded to a receiver wafer, the donor wafer will be mounted with the bonding surface of the transfer layer (e.g., dies or other selective transfer components) face down on the chuck of the laser tool (see, e.g., FIG. 8B (chuck not shown)). The contact between transfer layer and the chuck can potentially damage the transfer layer, which may cause problems when the donor wafer is subsequently bonded to a receiver wafer. Various approaches could be used to protect the transfer layer during the blanket laser release, such as a customized chuck design or sacrificial protective layers, but those approaches require new tooling (e.g., a custom chuck) or additional processing (e.g., deposition/removal of protective layers). Accordingly, in the illustrated example, an alternative process flow is presented that avoids contact between the donor wafer surface and the chuck during the blanket laser release, without any modified tooling or additional processing.

In the illustrated process flow, the transfer from the donor wafer 1400 to the first receiver wafer 1410a is performed using standard tools. For example, as shown in FIG. 14A, the first receiver wafer 1410a is bonded to the donor wafer 1400 prior to the laser release process using a standard bonding tool (e.g., selectively bonding the target dies 1404a on the donor 1400 to the bonding mesas 1412 (or other types of adhesive areas) on the receiver 1410a). Since no offset is required between the bonded donor/receiver wafer pair for the first transfer from the donor 1400, the bonded wafer pair can be transported between tools using standard handling systems. Thus, the bonded wafer pair may be transferred to a standard laser debond tool to perform the blanket laser release (e.g., using a laser 1420 to weaken the entire release layer 1402 on the donor 1400). After the blanket release, the donor wafer 1400 and the receiver wafer 1410a are mechanically separated, causing the target dies 1404a to fully debond from the donor 1400 and remain on the receiver 1410a.

All subsequent transfers from the donor wafer 1400 to the remaining receiver wafers (e.g., the 2nd through nth receivers) are performed using the new bond/debond tool 1100. For example, as shown in FIG. 14B, the second receiver wafer 1410b is bonded to the donor wafer 1400 at an offset and then immediately separated and debonded from the donor wafer 1400, causing the target dies 1404b to fully debond from the donor 1400 and remain on the receiver 1410b.

*Example Embodiments*

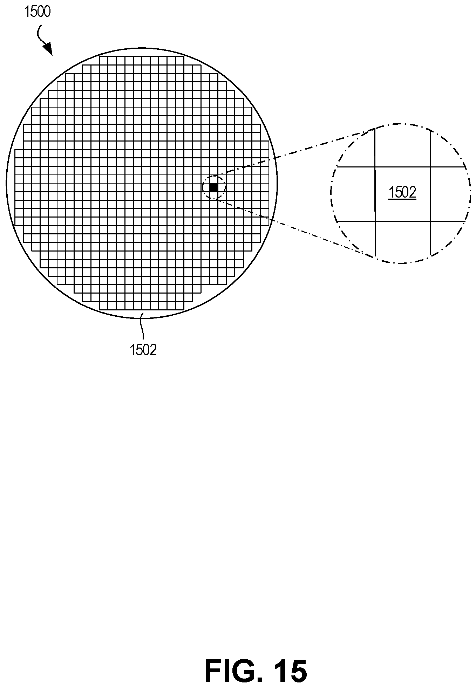

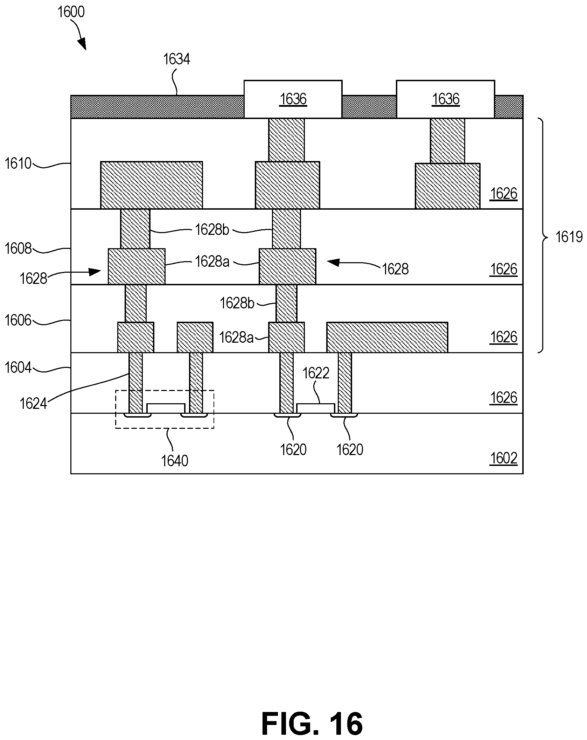

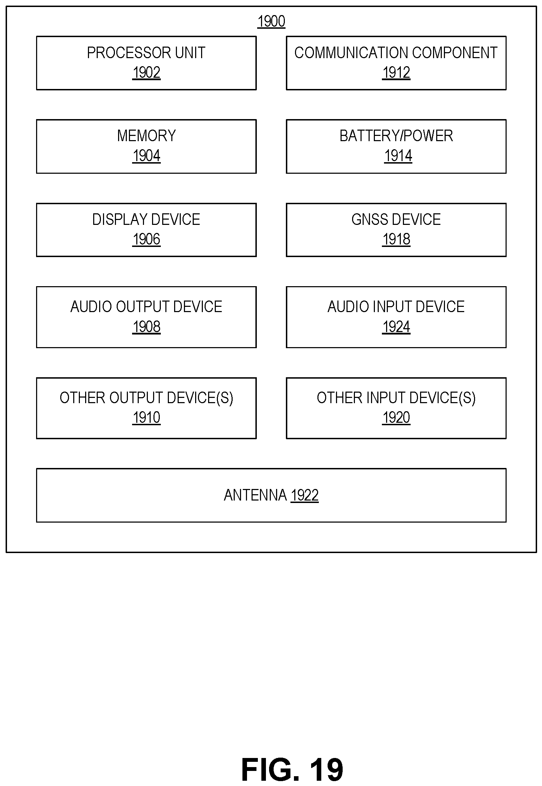

**FIG. 15** is a top view of a wafer 1500 and dies 1502 that may be included in any of the embodiments disclosed herein. The wafer 1500 may be composed of semiconductor material and may include one or more dies 1502 having integrated circuit structures formed on a surface of the wafer 1500. The individual dies 1502 may be a repeating unit of an integrated circuit product that includes any suitable integrated circuit. After the fabrication of the semiconductor product is complete, the wafer 1500 may undergo a singulation process in which the dies 1502 are separated from one another to provide discrete "chips" of the integrated circuit product. The die 1502 may be any of the dies disclosed herein. The die 1502 may include one or more transistors (e.g., some of the transistors 1640 of FIG. 16, discussed below), supporting circuitry to route electrical signals to the transistors, passive components (e.g., signal traces, resistors, capacitors, or inductors), and/or any other integrated circuit components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processor unit (e.g., the processor unit 1902 of FIG. 19) or other logic that is configured to store information in the memory devices or execute instructions stored in the memory array. Various ones of the microelectronic assemblies disclosed herein may be manufactured using a die-to-wafer assembly technique in which some dies are attached to a wafer 1500 that include others of the dies, and the wafer 1500 is subsequently singulated.

**FIG. 16** is a cross-sectional side view of an integrated circuit device 1600 that may be included in any of the embodiments disclosed herein (e.g., in any of the dies). One or more of the integrated circuit devices 1600 may be included in one or more dies 1502 (FIG. 15). The integrated circuit device 1600 may be formed on a die substrate 1602 (e.g., the wafer 1500 of FIG. 15) and may be included in a die (e.g., the die 1502 of FIG. 15). The die substrate 1602 may be a semiconductor substrate composed of semiconductor material systems including, for example, n-type or p-type materials systems (or a combination of both). The die substrate 1602 may include, for example, a crystalline substrate formed using a bulk silicon or a silicon-on-insulator (SOI) substructure. In some embodiments, the die substrate 1602 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1602. Although a few examples of materials from which the die substrate 1602 may be formed are described here, any material that may serve as a foundation for an integrated circuit device 1600 may be used. The die substrate 1602 may be part of a singulated die (e.g., the dies 1502 of FIG. 15) or a wafer (e.g., the wafer 1500 of FIG. 15).

The integrated circuit device 1600 may include one or more device layers 1604 disposed on the die substrate 1602. The device layer 1604 may include features of one or more transistors 1640 (e.g., metal oxide semiconductor field-effect transistors (MOSFETs)) formed on the die substrate 1602. The transistors 1640 may include, for example, one or more source and/or drain (S/D) regions 1620, a gate 1622 to control current flow between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 16 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

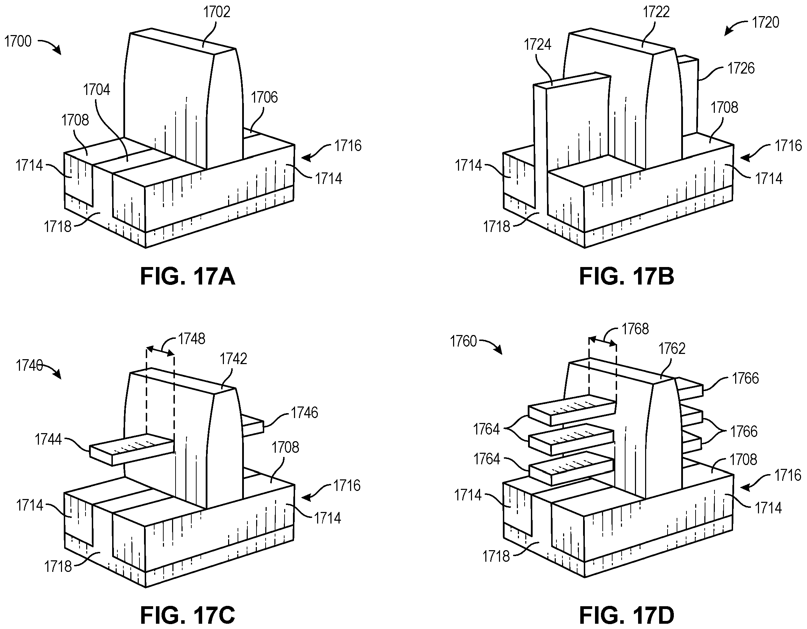

**FIGS. 17A-D** are simplified perspective views of example planar, FinFET, gate-all-around, and stacked gate-all-around transistors that may be included in any of the embodiments disclosed herein (e.g., in any of the dies). The transistors illustrated in FIGS. 17A-17D are formed on a substrate 1716 having a surface 1708. Isolation regions 1714 separate the source and drain regions of the transistors from other transistors and from a bulk region 1718 of the substrate 1716.

FIG. 17A is a perspective view of an example planar transistor 1700 comprising a gate 1702 that controls current flow between a source region 1704 and a drain region 1706. The transistor 1700 is planar in that the source region 1704 and the drain region 1706 are planar with respect to the substrate surface 1708.

FIG. 17B is a perspective view of an example FinFET transistor 1720 comprising a gate 1722 that controls current flow between a source region 1724 and a drain region 1726. The transistor 1720 is non-planar in that the source region 1724 and the drain region 1726 comprise "fins" that extend upwards from the substrate surface 1728. As the gate 1722 encompasses three sides of the semiconductor fin that extends from the source region 1724 to the drain region 1726, the transistor 1720 can be considered a tri-gate transistor. FIG. 17B illustrates one S/D fin extending through the gate 1722, but multiple S/D fins can extend through the gate of a FinFET transistor.

FIG. 17C is a perspective view of a gate-all-around (GAA) transistor 1740 comprising a gate 1742 that controls current flow between a source region 1744 and a drain region 1746. The transistor 1740 is non-planar in that the source region 1744 and the drain region 1746 are elevated from the substrate surface 1728.

FIG. 17D is a perspective view of a GAA transistor 1760 comprising a gate 1762 that controls current flow between multiple elevated source regions 1764 and multiple elevated drain regions 1766. The transistor 1760 is a stacked GAA transistor as the gate controls the flow of current between multiple elevated S/D regions stacked on top of each other. The transistors 1740 and 1760 are considered gate-all-around transistors as the gates encompass all sides of the semiconductor portions that extends from the source regions to the drain regions. The transistors 1740 and 1760 can alternatively be referred to as nanowire, nanosheet, or nanoribbon transistors depending on the width (e.g., widths 1748 and 1768 of transistors 1740 and 1760, respectively) of the semiconductor portions extending through the gate.

Returning to FIG. 16, a transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the die substrate 1602 and two sidewall portions that are substantially perpendicular to the top surface of the die substrate 1602. In other embodiments, at least one of the metal layers that form the gate electrode may simply be a planar layer that is substantially parallel to the top surface of the die substrate 1602 and does not include sidewall portions substantially perpendicular to the top surface of the die substrate 1602. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the die substrate 1602 adjacent to the gate 1622 of individual transistors 1640. The S/D regions 1620 may be formed using an implantation/diffusion process or an etching/-deposition process, for example. In the former process, dopants such as boron, aluminum, antimony, phosphorous, or arsenic may be ion-implanted into the die substrate 1602 to form the S/D regions 1620. An annealing process that activates the dopants and causes them to diffuse farther into the die substrate 1602 may follow the ion-implantation process. In the latter process, the die substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., transistors 1640) of the device layer 1604 through one or more interconnect layers disposed on the device layer 1604 (illustrated in FIG. 16 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the integrated circuit device 1600.

The interconnect structures 1628 may be arranged within the interconnect layers 1606-1610 to route electrical signals according to a wide variety of designs; in particular, the arrangement is not limited to the particular configuration of interconnect structures 1628 depicted in FIG. 16. Although a particular number of interconnect layers 1606-1610 is depicted in FIG. 16, embodiments of the present disclosure include integrated circuit devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the die substrate 1602 upon which the device layer 1604 is formed. For example, the lines 1628a may route electrical signals in a direction in and out of the page and/or in a direction across the page from the perspective of FIG. 16. The vias 1628b may be arranged to route electrical signals in a direction of a plane that is substantially perpendicular to the surface of the die substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 16. In some embodiments, dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same. The device layer 1604 may include a dielectric material 1626 disposed between the transistors 1640 and a bottom layer of the metallization stack as well. The dielectric material 1626 included in the device layer 1604 may have a different composition than the dielectric material 1626 included in the interconnect layers 1606-1610; in other embodiments, the composition of the dielectric material 1626 in the device layer 1604 may be the same as a dielectric material 1626 included in any one of the interconnect layers 1606-1610.

A first interconnect layer 1606 (referred to as Metal 1 or "M1") may be formed directly on the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604. The vias 1628b of the first interconnect layer 1606 may be coupled with the lines 1628a of a second interconnect layer 1608.

The second interconnect layer 1608 (referred to as Metal 2 or "M2") may be formed directly on the first interconnect layer 1606. In some embodiments, the second interconnect layer 1608 may include via 1628b to couple the lines 1628 of the second interconnect layer 1608 with the lines 1628a of a third interconnect layer 1610. Although the lines 1628a and the vias 1628b are structurally delineated with a line within individual interconnect layers for the sake of clarity, the lines 1628a and the vias 1628b may be structurally and/or materially contiguous (e.g., simultaneously filled during a dual-damascene process) in some embodiments.

The third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the integrated circuit device 1600 (i.e., farther away from the device layer 1604) may be thicker that the interconnect layers that are lower in the metallization stack 1619, with lines 1628a and vias 1628b in the higher interconnect layers being thicker than those in the lower interconnect layers.

The integrated circuit device 1600 may include a solder resist material 1634 (e.g., polyimide or similar material) and one or more conductive contacts 1636 formed on the interconnect layers 1606-1610. In FIG. 16, the conductive contacts 1636 are illustrated as taking the form of bond pads. The conductive contacts 1636 may be electrically coupled with the interconnect structures 1628 and configured to route the electrical signals of the transistor(s) 1640 to external devices. For example, solder bonds may be formed on the one or more conductive contacts 1636 to mechanically and/or electrically couple an integrated circuit die including the integrated circuit device 1600 with another component (e.g., a printed circuit board). The integrated circuit device 1600 may include additional or alternate structures to route the electrical signals from the interconnect layers 1606-1610; for example, the conductive contacts 1636 may include other analogous features (e.g., posts) that route the electrical signals to external components. The conductive contacts 1636 may serve as any of the conductive contacts described throughout this disclosure.

In some embodiments in which the integrated circuit device 1600 is a double-sided die, the integrated circuit device 1600 may include another metallization stack (not shown) on the opposite side of the device layer(s) 1604. This metallization stack may include multiple interconnect layers as discussed above with reference to the interconnect layers 1606-1610, to provide conductive pathways (e.g., including conductive lines and vias) between the device layer(s) 1604 and additional conductive contacts (not shown) on the opposite side of the integrated circuit device 1600 from the conductive contacts 1636. These additional conductive contacts may serve as any of the conductive contacts described throughout this disclosure.

In other embodiments in which the integrated circuit device 1600 is a double-sided die, the integrated circuit device 1600 may include one or more through silicon vias (TSVs) through the die substrate 1602; these TSVs may make contact with the device layer(s) 1604, and may provide conductive pathways between the device layer(s) 1604 and additional conductive contacts (not shown) on the opposite side of the integrated circuit device 1600 from the conductive contacts 1636. These additional conductive contacts may serve as any of the conductive contacts described throughout this disclosure. In some embodiments, TSVs extending through the substrate can be used for routing power and ground signals from conductive contacts on the opposite side of the integrated circuit device 1600 from the conductive contacts 1636 to the transistors 1640 and any other components integrated into the die 1600, and the metallization stack 1619 can be used to route I/O signals from the conductive contacts 1636 to transistors 1640 and any other components integrated into the die 1600.

Multiple integrated circuit devices 1600 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

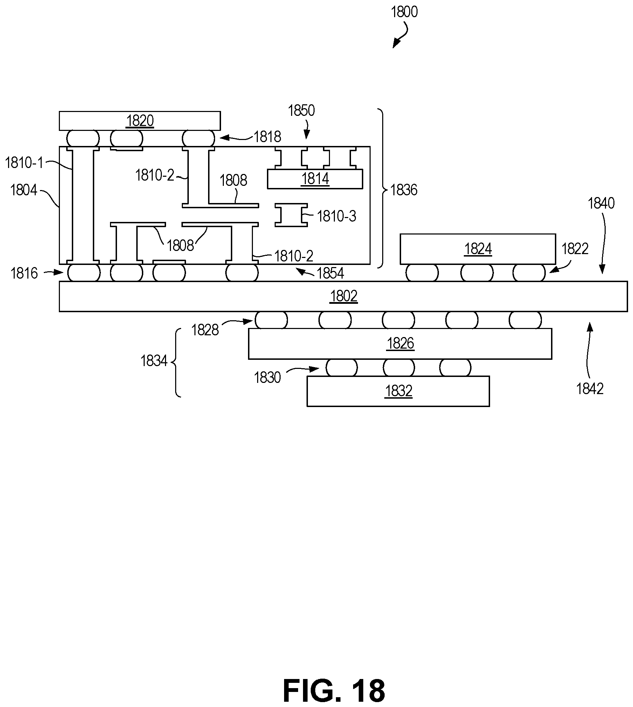

**FIG. 18** is a cross-sectional side view of an integrated circuit device assembly 1800 that may include any of the embodiments disclosed herein (e.g., IC components, such as dies, selectively transferred from donor wafers). In some embodiments, the integrated circuit device assembly 1800 may be a microelectronic assembly. The integrated circuit device assembly 1800 includes a number of components disposed on a circuit board 1802 (which may be a motherboard, system board, mainboard, etc.). The integrated circuit device assembly 1800 includes components disposed on a first face 1840 of the circuit board 1802 and an opposing second face 1842 of the circuit board 1802; generally, components may be disposed on one or both faces 1840 and 1842. Any of the integrated circuit components discussed below with reference to the integrated circuit device assembly 1800 may take the form of any suitable ones of the embodiments of the microelectronic assemblies disclosed herein.

In some embodiments, the circuit board 1802 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1802. In other embodiments, the circuit board 1802 may be a non-PCB substrate. The integrated circuit device assembly 1800 illustrated in FIG. 18 includes a package-on-interposer structure 1836 coupled to the first face 1840 of the circuit board 1802 by coupling components 1816. The coupling components 1816 may electrically and mechanically couple the package-on-interposer structure 1836 to the circuit board 1802, and may include solder balls (as shown in FIG. 18), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1816 may serve as the coupling components illustrated or described for any of the substrate assembly or substrate assembly components described herein, as appropriate.

The package-on-interposer structure 1836 may include an integrated circuit component 1820 coupled to an interposer 1804 by coupling components 1818. The coupling components 1818 may take any suitable form for the application, such as the forms discussed above with reference to the coupling components 1816. Although a single integrated circuit component 1820 is shown in FIG. 18, multiple integrated circuit components may be coupled to the interposer 1804; indeed, additional interposers may be coupled to the interposer 1804. The interposer 1804 may provide an intervening substrate used to bridge the circuit board 1802 and the integrated circuit component 1820.

The integrated circuit component 1820 may be a packaged or unpackaged integrated circuit product that includes one or more integrated circuit dies (e.g., the die 1502 of FIG. 15, the integrated circuit device 1600 of FIG. 16) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1820, a single monolithic integrated circuit die comprises solder bumps attached to contacts on the die. The solder bumps allow the die to be directly attached to the interposer 1804. The integrated circuit component 1820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1820 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel® embedded multi-die interconnect bridges (EMIBs)), or combinations thereof.

Generally, the interposer 1804 may spread connections to a wider pitch or reroute a connection to a different connection. For example, the interposer 1804 may couple the integrated circuit component 1820 to a set of ball grid array (BGA) conductive contacts of the coupling components 1816 for coupling to the circuit board 1802. In the embodiment illustrated in FIG. 18, the integrated circuit component 1820 and the circuit board 1802 are attached to opposing sides of the interposer 1804; in other embodiments, the integrated circuit component 1820 and the circuit board 1802 may be attached to a same side of the interposer 1804. In some embodiments, three or more components may be interconnected by way of the interposer 1804.

In some embodiments, the interposer 1804 may be formed as a PCB, including multiple metal layers separated from one another by layers of dielectric material and interconnected by electrically conductive vias. In some embodiments, the interposer 1804 may be formed of an epoxy resin, a fiberglass-reinforced epoxy resin, an epoxy resin with inorganic fillers, a ceramic material, or a polymer material such as polyimide. In some embodiments, the interposer 1804 may be formed of alternate rigid or flexible materials that may include the same materials described above for use in a semiconductor substrate, such as silicon, germanium, and other group III-V and group IV materials. The interposer 1804 may include metal interconnects 1808 and vias 1810, including but not limited to through hole vias 1810-1 (that extend from a first face 1850 of the interposer 1804 to a second face 1854 of the interposer 1804), blind vias 1810-2 (that extend from the first or second faces 1850 or 1854 of the interposer 1804 to an internal metal layer), and buried vias 1810-3 (that connect internal metal layers).

In some embodiments, the interposer 1804 can comprise a silicon interposer. Through silicon vias (TSV) extending through the silicon interposer can connect connections on a first face of a silicon interposer to an opposing second face of the silicon interposer. In some embodiments, an interposer 1804 comprising a silicon interposer can further comprise one or more routing layers to route connections on a first face of the interposer 1804 to an opposing second face of the interposer 1804.

The interposer 1804 may further include embedded devices 1814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1804. The package-on-interposer structure 1836 may take the form of any of the package-on-interposer structures known in the art. In embodiments where the interposer is a non-printed circuit board

The integrated circuit device assembly 1800 may include an integrated circuit component 1824 coupled to the first face 1840 of the circuit board 1802 by coupling components 1822. The coupling components 1822 may take the form of any of the embodiments discussed above with reference to the coupling components 1816, and the integrated circuit component 1824 may take the form of any of the embodiments discussed above with reference to the integrated circuit component 1820.

The integrated circuit device assembly 1800 illustrated in FIG. 18 includes a package-on-package structure 1834 coupled to the second face 1842 of the circuit board 1802 by coupling components 1828. The package-on-package structure 1834 may include an integrated circuit component 1826 and an integrated circuit component 1832 coupled together by coupling components 1830 such that the integrated circuit component 1826 is disposed between the circuit board 1802 and the integrated circuit component 1832. The coupling components 1828 and 1830 may take the form of any of the embodiments of the coupling components 1816 discussed above, and the integrated circuit components 1826 and 1832 may take the form of any of the embodiments of the integrated circuit component 1820 discussed above. The package-on-package structure 1834 may be configured in accordance with any of the package-on-package structures known in the art.

**FIG. 19** is a block diagram of an example electrical device 1900 that may include one or more of the embodiments disclosed herein. For example, any suitable ones of the components of the electrical device 1900 may include one or more selectively transferred IC components (e.g., dies), integrated circuit device assemblies 1800, integrated circuit components 1820, integrated circuit devices 1600, or integrated circuit dies 1502 disclosed herein. A number of components are illustrated in FIG. 19 as included in the electrical device 1900, but any one or more of these components may be omitted or duplicated, as suitable for the application. In some embodiments, some or all of the components included in the electrical device 1900 may be attached to one or more motherboards mainboards, or system boards. In some embodiments, one or more of these components are fabricated onto a single system-on-a-chip (SoC) die.

Additionally, in various embodiments, the electrical device 1900 may not include one or more of the components illustrated in FIG. 19, but the electrical device 1900 may include interface circuitry for coupling to the one or more components. For example, the electrical device 1900 may not include a display device 1906, but may include display device interface circuitry (e.g., a connector and driver circuitry) to which a display device 1906 may be coupled. In another set of examples, the electrical device 1900 may not include an audio input device 1924 or an audio output device 1908, but may include audio input or output device interface circuitry (e.g., connectors and supporting circuitry) to which an audio input device 1924 or audio output device 1908 may be coupled.

The electrical device 1900 may include one or more processor units 1902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1900 may include a memory 1904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1904 may include memory that is located on the same integrated circuit die as the processor unit 1902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1900 can comprise one or more processor units 1902 that are heterogeneous or asymmetric to another processor unit 1902 in the electrical device 1900. There can be a variety of differences between the processing units 1902 in a system in terms of a spectrum of metrics of merit including architectural, microarchitectural, thermal, power consumption characteristics, and the like. These differences can effectively manifest themselves as asymmetry and heterogeneity among the processor units 1902 in the electrical device 1900.

In some embodiments, the electrical device 1900 may include a communication component 1912 (e.g., one or more communication components). For example, the communication component 1912 can manage wireless communications for the transfer of data to and from the electrical device 1900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1912 may operate in accordance with other wireless protocols in other embodiments. The electrical device 1900 may include an antenna 1922 to facilitate wireless communications and/or to receive other wireless communications (such as AM or FM radio transmissions).

In some embodiments, the communication component 1912 may manage wired communications, such as electrical, optical, or any other suitable communication protocols (e.g., IEEE 802.3 Ethernet standards). As noted above, the communication component 1912 may include multiple communication components. For instance, a first communication component 1912 may be dedicated to shorter-range wireless communications such as Wi-Fi or Bluetooth, and a second communication component 1912 may be dedicated to longer-range wireless communications such as global positioning system (GPS), EDGE, GPRS, CDMA, WiMAX, LTE, EV-DO, or others. In some embodiments, a first communication component 1912 may be dedicated to wireless communications, and a second communication component 1912 may be dedicated to wired communications.

The electrical device 1900 may include battery/-power circuitry 1914. The battery/power circuitry 1914 may include one or more energy storage devices (e.g., batteries or capacitors) and/or circuitry for coupling components of the electrical device 1900 to an energy source separate from the electrical device 1900 (e.g., AC line power).

The electrical device 1900 may include a display device 1906 (or corresponding interface circuitry, as discussed above). The display device 1906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1900 may include an audio output device 1908 (or corresponding interface circuitry, as discussed above). The audio output device 1908 may include any embedded or wired or wirelessly connected external device that generates an audible indicator, such speakers, headsets, or earbuds.

The electrical device 1900 may include an audio input device 1924 (or corresponding interface circuitry, as discussed above). The audio input device 1924 may include any embedded or wired or wirelessly connected device that generates a signal representative of a sound, such as microphones, microphone arrays, or digital instruments (e.g., instruments having a musical instrument digital interface (MIDI) output). The electrical device 1900 may include a Global Navigation Satellite System (GNSS) device 1918 (or corresponding interface circuitry, as discussed above), such as a Global Positioning System (GPS) device. The GNSS device 1918 may be in communication with a satellite-based system and may determine a geolocation of the electrical device 1900 based on information received from one or more GNSS satellites, as known in the art.

The electrical device 1900 may include other output device(s) 1910 (or corresponding interface circuitry, as discussed above). Examples of the other output device(s) 1910 may include an audio codec, a video codec, a printer, a wired or wireless transmitter for providing information to other devices, or an additional storage device.

The electrical device 1900 may include other input device(s) 1920 (or corresponding interface circuitry, as discussed above). Examples of the other input device(s) 1920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1900 may be any other electronic device that processes data. In some embodiments, the electrical device 1900 may comprise multiple discrete physical components. Given the range of devices that the electrical device 1900 can be manifested as in various embodiments, in some embodiments, the electrical device 1900 can be referred to as a computing device or a computing system.

*Examples*

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a microelectronic assembly, comprising: a layer comprising a dielectric material; and an integrated circuit (IC) die at least partially within the layer, wherein the IC die has a thickness of 5 micrometers ($\mu$m) or less, and wherein there is a seam between the IC die and portions of the layer around the IC die.

Example 2 includes the microelectronic assembly of Example 1, further comprising a mesa structure under the IC die, wherein the mesa structure has a similar footprint as the IC die.

Example 3 includes the microelectronic assembly of any of Examples 1-2, wherein: the layer is a first layer; and the microelectronic assembly further comprises a second layer under the IC die, wherein the IC die is bonded to the second layer via a bond interface, wherein the bond interface comprises a dielectric bond or a hybrid dielectric and metal bond.

Example 4 includes the microelectronic assembly of any of Examples 1-3, wherein: the IC die is a first IC die; the microelectronic assembly further comprises a second IC die at least partially within the layer; and the first IC die and the second IC die respectively comprise substrates formed from separate pieces of substrate material.

Example 5 includes the microelectronic assembly of any of Examples 1-4, wherein edges of the IC die are unchipped.

Example 6 includes the microelectronic assembly of any of Examples 1-5, wherein the IC die has an area of less than 1 millimeter $(mm)^2$.

Example 7 includes the microelectronic assembly of any of Examples 1-6, wherein the IC die has an asymmetrical shape, a non-convex shape, or a shape with an aspect ratio of at least 8:1.

Example 8 includes an electronic device, comprising: a layer comprising one or more materials; an integrated circuit (IC) component at least partially within the layer; and a mesa structure under the IC component, wherein the mesa structure has a similar footprint as the IC component, and wherein the IC component is bonded to the mesa structure.

Example 9 includes the electronic device of Example 8, wherein: the mesa structure comprises at least one of a dielectric material or a metal; and the IC component is bonded to the mesa structure via a dielectric bond, a metal bond, or a hybrid dielectric and metal bond.

Example 10 includes the electronic device of any of Examples 8-9, wherein there is a seam between the IC component and portions of the layer around the IC component.

Example 11 includes the electronic device of any of Examples 8-10, wherein the IC component comprises an IC die, an interconnect, a transistor, a diode, a resistor, a capacitor, an inductor, or a transformer.

Example 12 includes a method, comprising: receiving a first substrate, wherein the first substrate comprises a layer of integrated circuit (IC) components; receiving a second substrate, wherein the second substrate comprises one or more adhesive areas; partially bonding the first substrate to the second substrate, wherein one or more IC components on the first substrate are bonded to the one or more adhesive areas on the second substrate, wherein the one or more IC components are from the layer of IC components; and separating the first substrate from the second substrate, wherein the one or more IC components are separated from the first substrate and remain on the second substrate.

Example 13 includes the method of Example 12, wherein the layer of IC components comprises one or more IC dies, interconnects, transistors, diodes, resistors, capacitors, inductors, or transformers.

Example 14 includes the method of any of Examples 12-13, wherein the first substrate further comprises a base substrate and a release layer, wherein the release layer is over the base substrate, and wherein the layer of IC components is over the release layer.

Example 15 includes the method of Example 14, wherein receiving the first substrate comprises forming the first substrate, wherein forming the first substrate comprises: receiving the base substrate; forming the release layer over the base substrate; forming the layer of IC components over the release layer; and partially singulating the layer of IC components.

Example 16 includes the method of Example 15, wherein forming the layer of IC components over the release layer comprises: fabricating the layer of IC components over the release layer; or transferring the layer of IC components over the release layer.

Example 17 includes the method of any of Examples 14-16, wherein separating the first substrate from the second substrate comprises: releasing, at least partially, the one or more IC components from the release layer of the first substrate; and mechanically separating the first substrate from the second substrate.

Example 18 includes the method of Example 17, wherein releasing, at least partially, the one or more IC components from the release layer of the first substrate comprises: debonding the one or more IC components from the release layer using a laser; or weakening the release layer using a laser.

Example 19 includes the method of any of Examples 14-18, wherein the release layer comprises a metal.

Example 20 includes the method of any of Examples 12-19, wherein the one or more adhesive areas include one or more raised structures, wherein the one or more raised structures comprise at least one of a dielectric material or a metal.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features.

Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

The terms "substantially," "close," "approximately," "near," and "about," generally refer to being within +/- 10% of a target value (unless otherwise specified). Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terms "over", "under", "between", "adjacent", "to", and "on" as used herein may refer to a relative position of one layer or component with respect to other layers or components. For example, one layer "over", "under", or "on" another layer, "adjacent" to another layer, or bonded "to" another layer may be directly in contact with the other layer or may have one or more intervening layers. One layer "between" layers may be directly in contact with the layers or may have one or more intervening layers.

The meaning of "a," "an," and "the" include plural references. The meaning of "in" includes "in" and "on."

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views.

The term "package" generally refers to a self-contained carrier of one or more dice, where the dice are attached to or embedded in the package substrate, and may be encapsulated for protection, with integrated or wire-bonded interconnects between the dice, along with leads, pins, or bumps located on the external portions of the package substrate. The package may contain a single die, or multiple dice, providing respective functions. The package may be mounted on a printed circuit board for interconnection with other packaged integrated circuits and discrete components, forming a larger circuit.

The term "cored" generally refers to a substrate of an integrated circuit package built upon a board, card, or wafer comprising a non-flexible stiff material. Typically, a small printed circuit board is used as a core, upon which integrated circuit device and discrete passive components may be soldered. Typically, the core has vias extending from one side to the other, allowing circuitry on one side of the core to be coupled directly to circuitry on the opposite side of the core. The core may also serve as a platform for building up layers of conductors and dielectric materials.

The term "coreless" generally refers to a substrate of an integrated circuit package having no core. The lack of a core may allow for higher-density package architectures, as the through-vias may have relatively large dimensions and pitch compared to high-density interconnects.

The term "land side" generally refers to the side of the substrate of the integrated circuit package closest to the plane of attachment to a printed circuit board, motherboard, or other package. This is in contrast to the term "die side", which generally refers to the side of the substrate of the integrated circuit package to which the die or dice are attached.

The terms "dielectric" and "dielectric material" generally refer to any type or number of non-electrically conductive materials. In some cases, dielectric material may be used to make up the structure of a package substrate. For example, dielectric material may be incorporated into an integrated circuit package as layers of laminate film or as a resin molded over integrated circuit dice mounted on the substrate.

The term "metallization" generally refers to metal layers formed on, over, and/or through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and may carry the same or similar meaning.

The term "bump" generally refers to a conductive layer or structure formed on a bond pad, which is typically made of solder or metal and has a round or curved shape, hence the term "bump".

The term "substrate" generally refers to a planar platform comprising dielectric and/or metallization structures. A substrate may mechanically support and electrically couple one or more IC dies on a single platform, with encapsulation of the one or more IC dies by a moldable dielectric material. A substrate may include bumps or pads as bonding interconnects on one or both sides. For example, one side of the substrate, generally referred to as the "die side", may include bumps or pads for chip or die bonding. The opposite side of the substrate, generally referred to as the "land side", may include bumps or pads for bonding the package to a printed circuit board.

The term "assembly" generally refers to a grouping of parts into a single functional unit. For example, certain parts may be permanently bonded together, integrated together, and/or mechanically assembled (e.g., where parts may be removable) into a functional unit.

The terms "coupled" or "connected" means a direct or indirect connection, such as a direct electrical, mechanical, magnetic, or fluidic connection between the things that are connected or an indirect connection, through one or more passive or active intermediary devices.

The term "circuit" or "module" may refer to one or more passive and/or active components that are arranged to cooperate with one another to provide a desired function. The term "signal" may refer to at least one current signal, voltage signal, magnetic signal, or data/clock signal.

## Claims

1.   A microelectronic assembly, comprising:

a layer comprising a dielectric material; and
an integrated circuit (IC) die at least partially within the layer, wherein the IC die has a thickness of 5 micrometers ($\mu$m) or less, and wherein there is a seam between the IC die and portions of the layer around the IC die.

2.   The microelectronic assembly of Claim 1, further comprising a mesa structure under the IC die, wherein the mesa structure has a similar footprint as the IC die.

3.   The microelectronic assembly of any of Claims 1-2, wherein:

the layer is a first layer; and
the microelectronic assembly further comprises a second layer under the IC die, wherein the IC die is bonded to the second layer via a bond interface, wherein the bond interface comprises a dielectric bond or a hybrid dielectric and metal bond.

4.   The microelectronic assembly of any of Claims 1-3, wherein:

the IC die is a first IC die;
the microelectronic assembly further comprises a second IC die at least partially within the layer; and
the first IC die and the second IC die respectively comprise substrates formed from separate pieces of substrate material.

5.   The microelectronic assembly of any of Claims 1-4, wherein edges of the IC die are unchipped.

6.   The microelectronic assembly of any of Claims 1-5, wherein the IC die has an area of less than 1 millimeter (mm)$^2$.

7.   A method, comprising:

receiving a first substrate, wherein the first substrate comprises a layer of integrated circuit (IC) components;
receiving a second substrate, wherein the second substrate comprises one or more adhesive areas;
partially bonding the first substrate to the second substrate, wherein one or more IC components on the first substrate are bonded to the one or more adhesive areas on the second substrate, wherein the one or more IC components are from the layer of IC components; and
separating the first substrate from the second substrate, wherein the one or more IC components are separated from the first substrate and remain on the second substrate.

8.   The method of Claim 7, wherein the layer of IC components comprises one or more IC dies, interconnects, transistors, diodes, resistors, capacitors, inductors, or transformers.

9. The method of any of Claims 7-8, wherein the first substrate further comprises a base substrate and a release layer, wherein the release layer is over the base substrate, and wherein the layer of IC components is over the release layer.

10. The method of Claim 9, wherein receiving the first substrate comprises forming the first substrate, wherein forming the first substrate comprises:

   receiving the base substrate;
   forming the release layer over the base substrate;
   forming the layer of IC components over the release layer; and
   partially singulating the layer of IC components.

11. The method of Claim 10, wherein forming the layer of IC components over the release layer comprises:

   fabricating the layer of IC components over the release layer; or
   transferring the layer of IC components over the release layer.

12. The method of any of Claims 9-11, wherein separating the first substrate from the second substrate comprises:

   releasing, at least partially, the one or more IC components from the release layer of the first substrate; and
   mechanically separating the first substrate from the second substrate.

13. The method of Claim 12, wherein releasing, at least partially, the one or more IC components from the release layer of the first substrate comprises:

   debonding the one or more IC components from the release layer using a laser; or
   weakening the release layer using a laser.

14. The method of any of Claims 7-13, wherein the one or more adhesive areas include one or more raised structures, wherein the one or more raised structures comprise at least one of a dielectric material or a metal.

15. At least one machine-accessible storage medium having instructions stored thereon, wherein the instructions, when executed on a machine, cause the machine to perform a method or realize an apparatus as claimed in any preceding claim.

FIG. 1A

FIG. 1B

FIG. 1C

FIG. 1D

FIG. 1E

FIG. 1F

FIG. 1G

FIG. 1H

FIG. 1I

EP 4 528 792 A2

FIG. 2A
FIG. 2B
FIG. 2C
FIG. 2D
FIG. 2E
FIG. 2F
FIG. 2G
FIG. 2H
FIG. 2I

FIG. 3A  FIG. 3B  FIG. 3C  FIG. 3D  FIG. 3E  FIG. 3F  FIG. 3G  FIG. 3H  FIG. 3I

**FIG. 4A**

**FIG. 4B**

**FIG. 4C**

FIG. 5A

FIG. 5B

FIG. 5C

FIG. 5D

FIG. 5E

FIG. 5F

33

DONOR WAFER 600

603

602

RECEIVER WAFER 610

602

Selective Layer Transfer

**FIG. 6B**

DONOR WAFER 600

602

RECEIVER WAFER 610

612

**FIG. 6A**

700

```
                    ┌─────────────┐
                    │    START    │
                    └──────┬──────┘
                           ▼
702 ┌────────────────────────────────────────────────────────┐
    │   RECEIVE DONOR SUBSTRATE WITH LAYER OF IC COMPONENTS   │
    └──────────────────────────┬─────────────────────────────┘
                               ▼
704 ┌────────────────────────────────────────────────────────┐
    │   RECEIVE RECEIVER SUBSTRATE PATTERNED WITH ADHESIVE    │
    │                         AREAS                          │
    └──────────────────────────┬─────────────────────────────┘
                               ▼
706 ┌────────────────────────────────────────────────────────┐
    │            PARTIALLY BOND DONOR TO RECEIVER            │
    │  (WITH TARGET IC COMPONENTS ON DONOR SELECTIVELY       │
    │    BONDED TO ADHESIVE AREAS ON RECEIVER)              │
    └──────────────────────────┬─────────────────────────────┘
                               ▼
708 ┌────────────────────────────────────────────────────────┐
    │       RELEASE TARGET IC COMPONENTS FROM DONOR /        │
    │          SEPARATE DONOR FROM RECEIVER                  │
    └──────────────────────────┬─────────────────────────────┘
                               ▼
710 ┌────────────────────────────────────────────────────────┐
    │             PERFORM REMAINING PROCESSING               │
    └──────────────────────────┬─────────────────────────────┘
                               ▼
                    ┌─────────────┐
                    │     END     │
                    └─────────────┘
```

# FIG. 7

800
802

DONOR

804a    804b    804a    804b

**FIG. 8A**

820

800
802

DONOR

804a    804b    804a    804b

**FIG. 8B**

804a    804b    804a    804b

800
802

DONOR

810a

RECEIVER

812    812

**FIG. 8C**

800
802

DONOR

804a    804b    804a    804b

810a

RECEIVER

812    812

**FIG. 8D**

804b    804b

800
802

DONOR

810b

RECEIVER

812    812

**FIG. 8E**

**FIG. 9A**

**FIG. 9B**

**FIG. 9C**

**FIG. 9D**

FIG. 10A

FIG. 10B

EP 4 528 792 A2

**FIG. 10C**

**FIG. 11**

EP 4 528 792 A2

**FIG. 12A**

**FIG. 12B**

FIG. 12C

EP 4 528 792 A2

1300

**FIG. 13**

**FIG. 14A**

**FIG. 14B**

EP 4 528 792 A2

**FIG. 15**

**FIG. 16**

FIG. 17A

FIG. 17B

FIG. 17C

FIG. 17D

FIG. 18

1900

| | |
|---|---|
| PROCESSOR UNIT 1902 | COMMUNICATION COMPONENT 1912 |
| MEMORY 1904 | BATTERY/POWER 1914 |
| DISPLAY DEVICE 1906 | GNSS DEVICE 1918 |
| AUDIO OUTPUT DEVICE 1908 | AUDIO INPUT DEVICE 1924 |
| OTHER OUTPUT DEVICE(S) 1910 | OTHER INPUT DEVICE(S) 1920 |

ANTENNA 1922

# FIG. 19